# EUROPÄISCHE PATENTANMELDUNG

(11) **EP 3 243 827 A1**
(43) Veröffentlichungstag der Anmeldung: **15.11.2017**
(21) Anmeldenummer: 16169644.8
(22) Anmeldetag: 13.05.2016
(51) Int. Cl.: C07F 5/02, C09K 11/06, H01L 51/00

(54) **DIAZADIBORINE, VERFAHREN ZUR HERSTELLUNG VON DIAZADIBORINEN SOWIE VERWENDUNG VON DIAZADIBORINEN**

(71) Anmelder: Justus-Liebig-Universität Gießen, 35390 Gießen (DE)
(72) Erfinder: Wegner, Hermann A., 35392 Gießen (DE); Lu, Zhenpin, 35392 Gießen (DE)
(74) Vertreter: Stumpf, Peter

(57) **Zusammenfassung**

Die Erfindung umfasst Diazadiborine, Verfahren zur Herstellung von Diazadiborinen via Umsetzung von Diborverbindungen mit Hydrazobenzolen oder Azobenzolen sowie die Verwendung von Diazadiborinen im Bereich molekularer Elektronik wie z. B. für OLEDs.

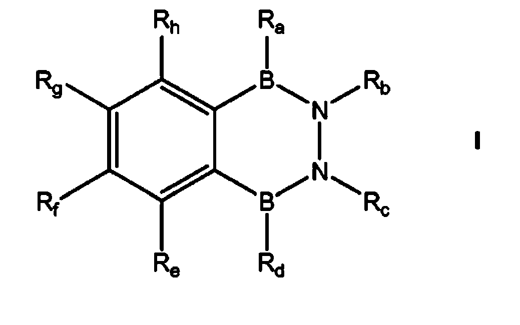

## Beschreibung

Die vorliegende Erfindung betrifft die neue Verbindungsklasse der Diazadiborine, insbesondere 1,2,3,6-Diazadiborine, ihre Herstellung und ihre Verwendung im Bereich organischer und/oder molekularer Elektronik. Sie betrifft auch elektronische Bauteile, die die hier offenbarten Diazadiborine enthalten. Die Bezeichnungen "organische Elektronik" und "molekulare Elektronik" werden im Rahmen dieser Offenbarung synonym verwendet und beziehen sich auf elektronischen Schaltkreise, die Bauteile enthalten, deren für die Funktion hauptsächlich verantwortliche Bestandteile aus mindestens jeweils einer organischen Substanz (Verbindung) aufgebaut sind.

### Beschreibung

Für die Anwendung auf dem Gebiet der molekularen Elektronik werden verschiedenste Substanzklassen bezüglich ihrer elektronischen Eigenschaften, ihrer Applizierbarkeit auf Trägersubstrate usw. hin untersucht. Als bis dato besonders vielversprechende Verbindungen gelten substituierte oder unsubstituierte polycyclische Aromaten, leitfähige Polymere und Graphen.

### Stand der Technik

Die im Stand der Technik bekannten Substanzen weisen jedoch einige große Nachteile auf. Polyzyklische Aromaten beispielsweise besitzen zwar gute halbleitende Eigenschaften, sind aber im Allgemeinen sehr schwer löslich und können daher nur mittels Dampfphasenabscheidung verarbeitet werden. Dies ist aufwendig und kostspielig. Weitere Probleme sind oft die Stabilität und die Kontrolle der Eigenschaften von polyzyklischen Aromaten, die einen Einbau von Heteroatomen interessant machen. Darüber hinaus ist bereits die Herstellung polyzyklischer Aromaten ebenfalls sehr aufwendig und kostspielig. Diese Nachteile ließen sich durch Verwendung von polycyclischen heteroaromatischen Substanzen teilweise bereits vermeiden. Die WO 2015043722 A1 offenbart beispielsweise Herstellung sowie Verwendung von 1,2-Azaborinen in organischen elektronischen Bauteilen, insbesondere organischen Leuchtdioden (OLED's - organic light emitting diodes), organischen photovoltaischen Zellen und organischen Photodetektoren. Die Patentschrift US 9,231,218 B2 offenbart substituierte Dibenzo[1,4]azaborine als phosphoreszierende Emittersubstanzen für OLED's sowie Vorrichtungen und Formulierungen, die diese Dibenzo[1,4]azaborine enthalten.

Durch die Einführung jeweils eines Bor- und Stickstoffatoms in ein polyzyklisches Grundgerüst konnten somit bereits einige Nachteile des Standes der Technik überwunden werden. Bekannt sind zum Beispiel Triphenylene mit B₂N₂C₂-(Teil-)Strukturen, die jedoch nur sehr aufwendig herzustellen sind. Weiterhin gibt es auch nur wenige Beispiele für die Herstellung von monocyclischen heteroaromatischen Verbindungen, die B₂N₂C₂-Strukturen enthalten, und deren Herstellung ist zudem ebenfalls sehr langwierig und kostenaufwendig, da die bisher bekannten Verfahren, um BN-heteroaromatische Verbindungen herzustellen, oftmals mehrstufig sind, übergangsmetallkatalysierter Kupplungsraktionen bedürfen und/oder die Verwendung toxischer metallorganischer Verbindungen wie zum Beispiel Stannanen verlangen. Es gibt somit bislang kein einfaches und kostengünstiges Verfahren, um polyzyklische heteroaromatische Verbindungen mit B₂N₂C₂-Strukturen herzustellen, das überdies auch noch zahlreiche unterschiedlichste Substituenten toleriert.

### Aufgabe

Aufgabe der vorliegenden Erfindung ist es somit, die Gruppe der für organische Elektronik verwendbaren Substanzklassen zu erweitern, d.h. neue organische Substanzen zur Verfügung zu stellen, die sowohl geeignete elektronische Eigenschaften für die Verwendung als aktive Materialien in organischer Elektronik aufweisen (beispielsweise Halbleitereigenschaften, Lichtabsorption, Elektronentransfer, Redoxpotential u.a.), als auch gut prozessierbar sowie einfach und kostengünstig herstellbar sind, ohne dabei die Nachteile der bekannten Substanzen aufzuweisen. Weiterhin ist es Aufgabe der Erfindung, ein einfaches und kostengünstiges sowie vielseitig einsetzbares Verfahren für die Herstellung der erfindungsgemäßen Diazadiborine bereitzustellen, das ohne den Einsatz von Übergangsmetall-Katalysatoren oder toxischen metallorganischen Verbindungen auskommt.

### Lösung der Aufgabe

Diese Aufgabe wird erfindungsgemäß gelöst durch die kennzeichnenden Merkmale der unabhängigen Ansprüche 1 (Produkt) und 9 (Verfahren). Die abhängigen Ansprüche zeigen weitere vorteilhafte Ausgestaltungen der Erfindung. Die Erfindung umfasst auch alle sinnvollen und insbesondere alle erwähnten Kombinationen von unabhängigen und/oder abhängigen Ansprüchen.

Überraschenderweise wurde gefunden, dass die Umsetzung von Bisboraten sowohl mit Hydrazobenzolen als auch mit Azobenzolen zu einer neuen Substanzklasse, den 1,2,3,6-Diazadiborinen führt (vgl. Schema 1 u. 2). Die durchgeführten Versuche zeigen, dass diese Reaktionsfolge, insbesondere bei Verwendung von Azobenzolen, zahlreiche unterschiedliche funktionelle Gruppen toleriert. Sowohl mit Elektronenakzeptoren substituierte als auch mit Elektronendonatoren substituierte Azobenzole können effektiv in die entsprechenden 1,2,3,6-Diazadiborine überführt werden. Es werden Ausbeuten von 30 % bis 63 % erhalten.

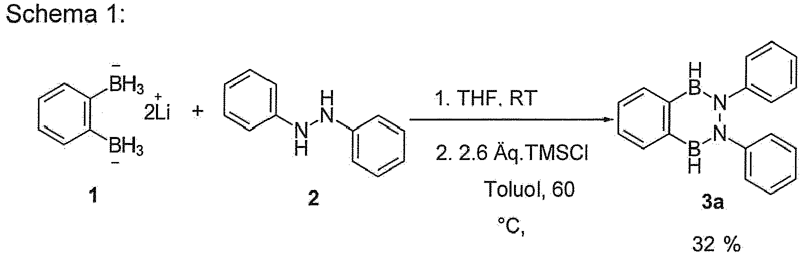

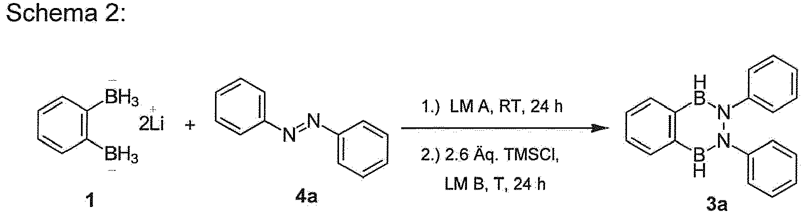

Da Hydrazobenzole üblicherweise aus Azobenzolen durch Reduktion hergestellt werden, stellt die Möglichkeit der direkten Verwendung von Azobenzolen eine besonders vorteilhafte Ausgestaltung der Erfindung dar. Dabei kann die jeweils verwendete bidentate Lewissäure gleichzeitig als reduzierendes Agens gegenüber dem eingesetzten Azobenzol fungieren, wobei die Wahl des Lösungsmittels, bzw. des Lösungsmittelgemisches besonders wichtig ist. Bezüglich Verbindung 3a ist es beispielsweise vorteilhaft, den ersten Verfahrensschritt in einem polaren Lösungsmittel (z.B. THF, DCM) durchzuführen anstelle von einem unpolaren (vgl. Schema 2, Tabelle 1).

In Versuchen wurde beispielsweise für die Umsetzung gemäß Schema 2 als geeignetste Lösungsmittelkombination eine Mischung von THF und Toluol ermittelt, wobei zunächst das polarere der beiden Lösungsmittel zugegeben wird.

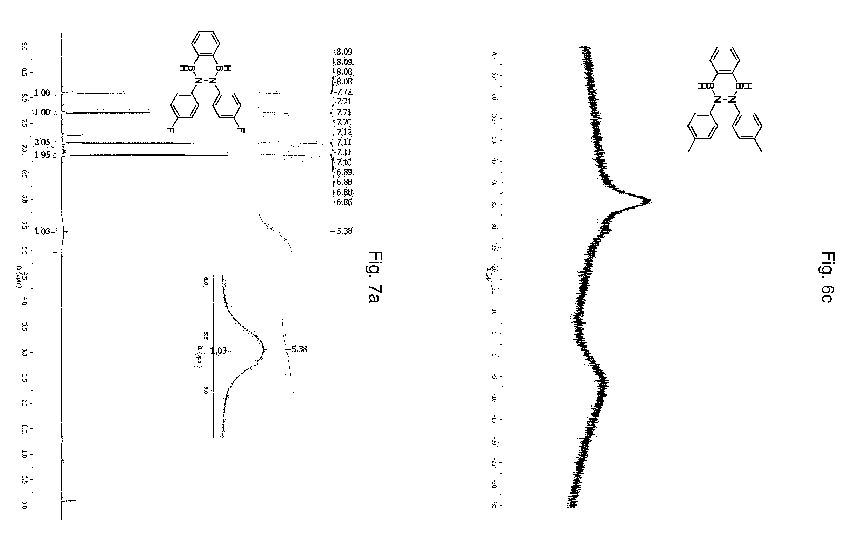

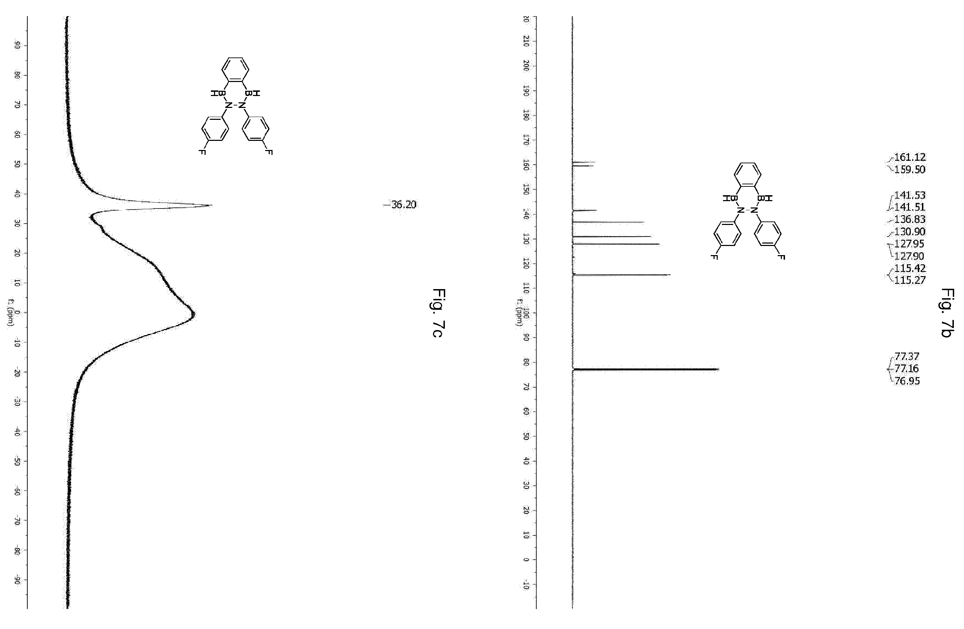

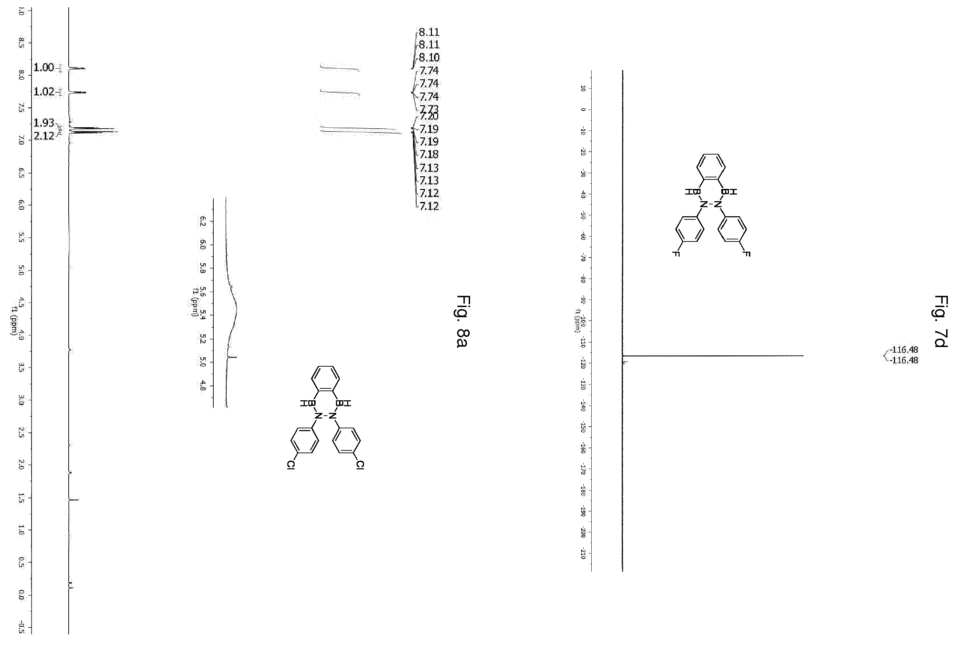

Verbindung **3a** weist im ¹¹B NMR-Spektrum in CDCl₃ (vgl. Fig. 7) ein Singulett-Signal bei 36.0 ppm auf, sowie im IR-Spektrum ein Signal bei 2531 cm⁻¹, das B-H-Schwingungen zugeordnet wird.

Auch ein- oder mehrfach substituierte sowie unsymmetrisch substituierte Azobenzole können erfolgreich in dem erfindungsgemäßen Verfahren zu den korrespondierenden substituierten 1,2,3,6-Diazadiborinen umgesetzt werden, wobei die unsymmetrisch substituierten Azoverbindungen geringere Ausbeuten (15 % bis 31 %) ergeben (vgl. Schemata 3, 4 und Tab. 2, 3).

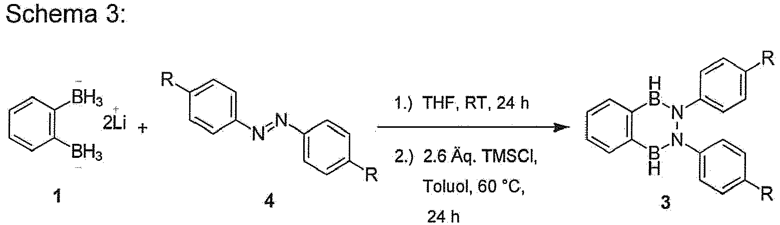

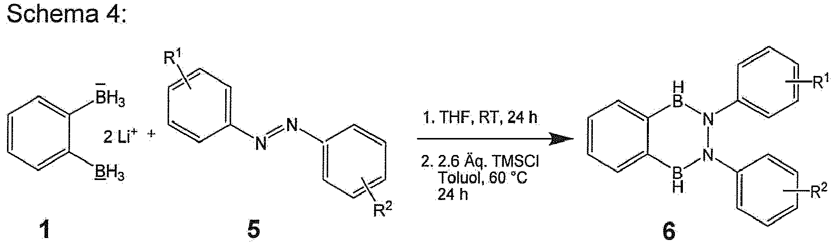

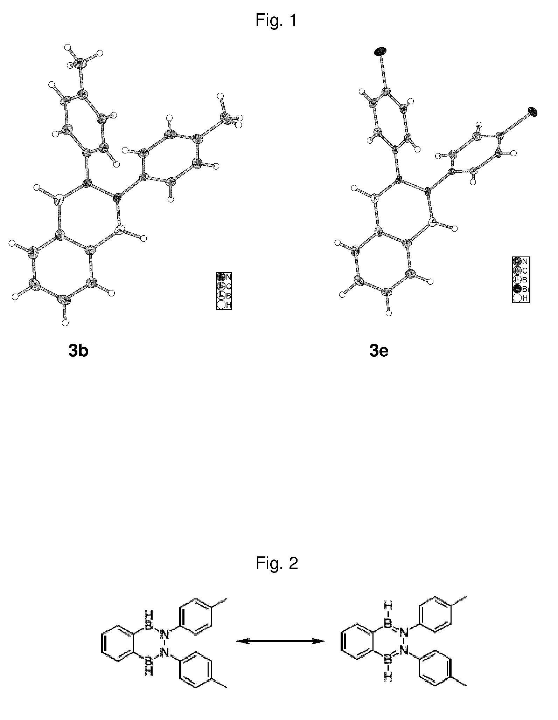

Von den Verbindungen **3b** und **3e** konnten durch Umkristallisation aus Toluol bei -20 °C Einkristalle gewonnen und röntgenkristallographisch (XRD) untersucht werden. Beide Verbindungen weisen nicht-planare leicht verdrehte Strukturen mit geringen Torsionswinkeln auf (vgl. Fig. 1). Im Falle von **3b** beträgt der Torsionswinkel B-N-N-B -4.3(3)° und der Torsionswinkel B-C-C-B 7.6(3)°; die Bindungslänge B-N beträgt 1.402(3) Å, was der literaturbekannten Länge einer lokalisierten B=N-Doppelbindung (1.403(2) A) entspricht. Dies deutet darauf hin, dass **3b** im wesentlichen die rechts in Fig. 2 gezeigte mesomere Grenzstruktur zuzuschreiben ist. Die Längen der B-C-Bindungen (1.535(3) A) und der N-N-Bindung (1.430(2) A) sind den literaturbekannten Bindungslängen von Phenylazetat-azaborin (B-C-Bindung, 1.498(3) A) und B₂C₂N₂-substituiertem Triphenylen (N-N-Bindung, 1.422(4) A) sehr ähnlich.

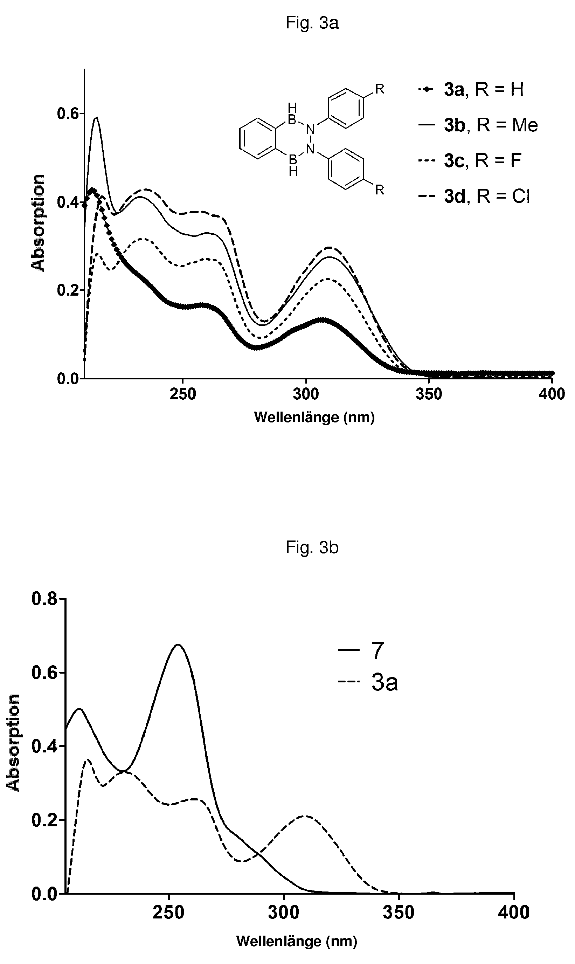

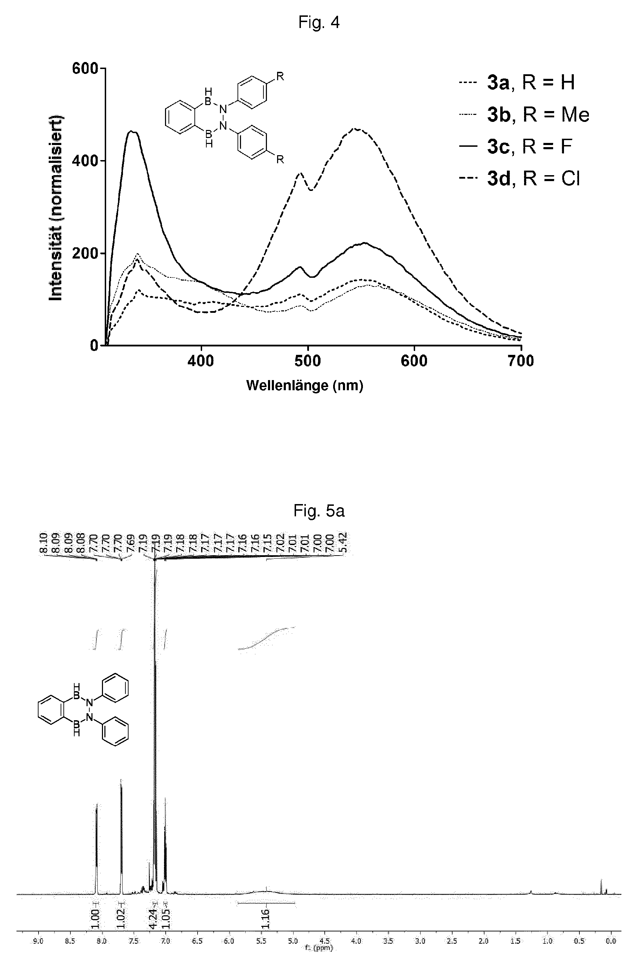

In Fig. 3a sind beispielhaft die UV-VIS-Spektren einiger 1,2,3,6-Diazadiborine widergegeben. Trotz unterschiedlicher Substituenten an den Phenylringen weisen sie alle im wesentlichen ähnliche Absorptionsmaxima bei 310 nm auf, was einer generellen und weitgehend substituentenunabhängigen bathochromen Verschiebung gegenüber Naphthalin und 2,3-Diphenylnaphthanlinen **7** (λ_{abs} = 275 nm und λ_{abs} = 254 nm, vgl. Fig. 3b) entspricht. Die UV-VIS-Spektren der Verbindungen **3a** bis **3d** ähneln somit denen bekannter 2,1-Borazanaphthalen-Derivaten (ca. 320 nm), so dass sie in gleicher Weise verwendet werden können, aber dabei wesentlich einfacher und kostengünstiger herstellbar sind. Alle Diazadiborine weisen im Fluoreszenzemissionsspektrum zwei Emissionsbanden auf, eine bei 340 nm und eine weitere bei 545 nm (Fig. 4). Bei Verbindung **3c** ist das Emissionsmaximum bei 340 nm intensiver als die niederenergetischere Bande. Verbindung **3d** weist ein entgegengesetztes Emissionsmuster auf, mit einer stärkeren Emission bei der niederenergetischeren Bande. Die Quantenausbeuten zweier dieser BNsubstituierten Naphthaline (**3b, 3c**) wurden gemäß der dem Fachmann bekannten Methode bestimmt und liegen bei < 0.01 [Messung in Cyclohexan, konstante Intervallbreite von 2.5 nm, Anregungswellenlänge: 310 nm, Integration von 322 nm bis 700 nm, Kalibrierungsstandards: Anthracen (Φ = 0.36) und 9-10-Diphenylanthracen (Φ = 0.97)].

Das erfindungsgemäße Verfahren ermöglicht es, ausgehend von allgemein verfügbaren Azoverbindungen und Hydrazoverbindungen, auf besonders einfache und kostengünstige Art und Weise bisher unbekannte Diazadiborine herzustellen. Diese erfindungsgemäßen Diazadiborine weisen vorteilhafte chemische, elektrochemische und/oder optische Eigenschaften auf, wodurch sie für den Aufbau von Bausteinen/Vorrichtungen im Bereich von molekularer Elektronik geeignet sind.

Die durchgeführten Versuche zeigen weiterhin, dass diese Reaktion gemäß Schema 5 allgemein eingesetzt werden kann und somit den einfachen Zugang zu polycyclischen heteroaromatischen Strukturen generell bietet.

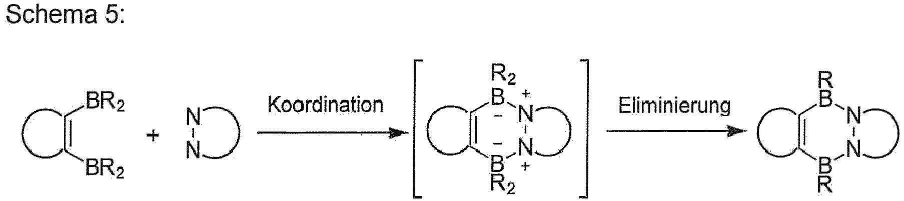

Die Erfindung beinhaltet somit eine oder mehrere Verbindungen, umfassend mindestens eine Diazadiborin-Teilstruktur der allgemeinen Formel I, 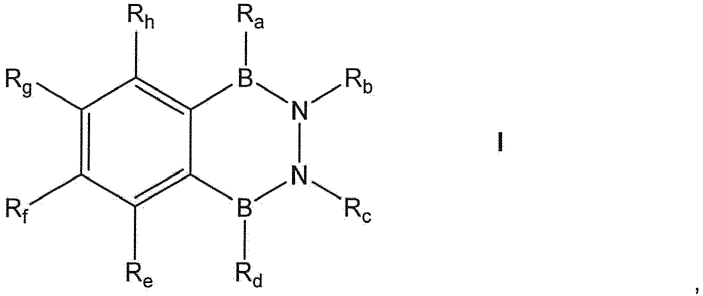 wobei es zwei grundsätzliche Ausgestaltungen gibt: In Variante A sind mindestens zwei der Reste Rₐ bis Rₕ über mindestens eine mindestens einatomige Brücke miteinander verknüpft, so dass die bizyklische Diazadiborin-Teilstruktur I Bestandteil der polyzyklischen aromatischen oder polyzyklischen heteroaromatischen Struktur der Verbindung ist, und diejenigen Reste Rₐ bis Rₕ, die nicht Teil der polyzyklischen aromatischen oder polyzyklischen heteroaromatischen Struktur der Verbindung sind, unabhängig voneinander ausgewählt sind aus der Liste umfassend H, F, Cl, Br, I, CN, OH, O-Alkyl, NH₂, N(Alkyl)₂, C₁-C₂₀-Alkyl, C₁-C₂₀-iso-Alkyl, C₃-C₂₀Cycloalkyl, Cyclopentadienyl, Aryl, Phenyl, Benzyl, Naphthyl, Heteroaryl, polyzyklische aromatische Reste, polyzyklische heteroaromatische Reste, substituiertes C₁-C₂₀-Alkyl, substituiertes C₁-C₂₀-iso-Alkyl, substituiertes C₃-C₂₀-Cycloalkyl, substituiertes Aryl, substituiertes Phenyl, substituiertes Benzyl, substituiertes Naphthyl, substituiertes Heteroaryl, substituierte polyzyklische aromatische Reste, substituierte polyzyklische heteroaromatische Reste, wobei bei den substituierten Resten dieser Liste mindestens ein Wasserstoffatom im Rest substituiert ist durch einen Rest, ausgewählt aus der Liste umfassend F, Cl, Br, I, CN, OH, O-Alkyl, NH₂, N(Alkyl)₂, C₁-C₂₀-Alkyl, Phenyl, Benzyl, wobei im Falle mehrfacher Substitution die Substituenten unabhängig voneinander ausgewählt sind. Die vorgenannten sowie alle weiteren hier offenbarten Listen sind nicht einschränkend zu verstehen. In Variante B handelt es sich bei den Resten Rₐ bis Rₕ um Reste, die unabhängig voneinander ausgewählt sind aus der Liste umfassend H, F, Cl, Br, I, CN, OH, O-Alkyl, NH₂, N(Alkyl)₂, C₁-C₂₀-Alkyl, C₁-C₂₀-iso-Alkyl, C₃-C₂₀-Cycloalkyl, Cyclopentadienyl, Aryl, Phenyl, Benzyl, Naphthyl, Heteroaryl, polyzyklische aromatische Reste, polyzyklische heteroaromatische Reste, substituiertes C₁-C₂₀-Alkyl, substituiertes C₁-C₂₀-iso-Alkyl, substituiertes C₃-C₂₀-Cycloalkyl, substituiertes Aryl, substituiertes Phenyl, substituiertes Benzyl, substituiertes Naphthyl, substituiertes Heteroaryl, substituierte polyzyklische aromatische Reste, substituierte polyzyklische heteroaromatische Reste, wobei bei den substituierten Resten dieser Liste mindestens ein Wasserstoffatom im Rest substituiert ist durch einen Rest, ausgewählt aus der Liste umfassend F, Cl, Br, I, CN, OH, O-Alkyl, NH₂, N(Alkyl)₂, C₁-C₂₀-Alkyl, Phenyl, Benzyl, wobei im Falle mehrfacher Substitution die Substituenten unabhängig voneinander ausgewählt sind.

Weiterhin beinhaltet die Erfindung mindestens eine Verbindung entsprechend dem vorstehend gesagten, wobei es sich bei der polyzyklischen aromatischen oder polyzyklischen heteroaromatischen Struktur dieser Verbindung, die die Teilstruktur gemäß Formel I enthält, um eine Struktur handelt, die als mindestens eine weitere Teilstruktur eine oder mehrere Teilstrukturen umfasst, ausgewählt aus der Liste umfassend die Strukturen von Naphthalin, Anthracen, Phenanthren, Phenalen, Tetracen, Pyren, Chrysen, lineares Pentacen, nicht-lineares Pentacen, lineares Hexacen, nicht-lineares Hexacen, Inden, Indacen, Fluoren, Acenaphthalen sowie höhermolekulare Homologe dieser Strukturen.

Weiterhin beinhaltet die Erfindung mindestens eine Verbindung gemäß dem oben gesagten, wobei, in der polyzyklischen Struktur randständig und/oder nicht randständig weitere Heteroatome mit oder ohne Substituenten enthalten sind, ausgewählt aus der Liste umfassend B, N, O, S, Se, NR', SiR'₂, wobei es sich bei R' unabhängig voneinander um H, C₁-C₄₀-Alkyl, C₁-C₄₀-Isoalkyl handeln kann.

Weiterhin beinhaltet die Erfindung mindestens eine Verbindung gemäß dem oben gesagten, wobei es sich um eine niedermolekulare Verbindung, ein Monomer, ein Dimer, ein Oligomer oder ein Polymer handelt.

Weiterhin beinhaltet die Erfindung mindestens eine Zubereitung, umfassend mindestens eine Verbindung gemäß einer der vorstehend beschriebenen Ausführungsvarianten, die mindestens eine der Eigenschaften elektrisch leitend, halbleitend, elektronenleitend, lochleitend, elektrisch isolierend, lichtleitend oder lichtemittierend aufweist. Als Zubereitung werden im Rahmen dieser Offenbarung nicht nur einfache physikalische Materialmischungen verstanden, wie man sie beispielsweise
a) durch Lösen mindestens einer erfindungsgemäßen Verbindung in einem Lösungsmittel/Lösungsmittelgemisch,
b) durch Dispersion einer oder mehrerer erfindungsgemäßer Verbindungen in einem Dispersionsmittel oder einer Mischung von Dispersionsmitteln mit oder ohne Zugabe von Hilfsstoffen wie z.B. Tensiden oder
c) Verreiben bzw. Vermahlen einer oder mehrerer erfindungsgemäßer Verbindungen alleine oder mit Hilfsstoffen in einem Mörser bzw. einer Mühle erhält. Vielmehr werden auch Polymerkomposite, Copolymere, compoundierte Polymere und ähnliche mindestens eine erfindungsgemäße Verbindung enthaltende Materialien als Zubereitungen im Sinne der Erfindung angesehen.

Weiterhin beinhaltet die Erfindung somit eine Zubereitung, umfassend mindestens eine der weiter oben aufgeführten erfindungsgemäßen Verbindungen sowie ein organisches Lösungsmittel oder Lösungsmittelgemisch.

Weiterhin beinhaltet die Erfindung die Verwendung einer oder mehrerer der obengenannten erfindungsgemäßen Verbindungen oder einer oder mehrerer der obengenannten erfindungsgemäßen Zubereitungen als Ladungstransport-Material, Halbleiter-Material, elektrisch leitendes Material, lichtleitendes- oder lichtemittierendes Material in optischen, elektrooptischen, elektronischen, elektrolumineszenten oder photolumineszenten Bauteilen oder Vorrichtungen.

Weiterhin beinhaltet die Erfindung ein oder mehrere Bauteile oder Vorrichtungen, die mindestens eine weiter oben beschriebene erfindungsgemäße Verbindung oder eine weiter oben beschriebene erfindungsgemäße Zubereitung umfassen. Beispiele für derartige Bauteile bzw. Vorrichtungen sind: Organische FeldeffektTransistoren (OFET), Dünnfilmtransistoren (TFT), Integrierte Schaltkreise (IC), Logik-Schaltkreise, Logik-Bausteine, Kondensatoren, Radio-Frequenz-Identifizierungs-Chips (RFID), organische Leuchtdioden (OLED), organische lichtemittierende Transistoren (OLET), Flachbildschirme, Flüssigkristallbildschirme, Hintergrundbeleuchtungen von Flüssigkristallbildschirmen, organische Photovoltaikbauteile (OPV), organische Solarzellen, Photodioden, Laserdioden, Photoleiter, organische Photoleiter, elektrophotographische Bauteile, elektrophotographische Aufzeichnungs-Bauteile, organische Speicherbauteile, Sensorbauteile, Sensoren, Ladungsinjektionsschichten, Ladungstransportschichten oder Zwischenschichten in polymeren Leuchtdioden (PLED), Schottky-Dioden, Ausgleichsschichten, antistatische Beschichtungen und Filme, Polymerelektrolytmembranen (PEM), leitende Substrate, leitfähige Strukturen, Elektrodenmaterialien in Batterien, Sensoren und Elektrolyseuren, Ausgleichsschichten, Biosensoren, Biochips, Sicherheitsmarkierungen, Sicherheits-Vorrichtungen, und Bauteile oder Vorrichtungen für den Nachweis und/oder die Unterscheidung von DNA- oder RNA-Sequenzen.

Dem Fachmann sind Ausgleichsschichten und Zwischenschichten sowie deren Verwendung bei der Herstellung der obengenannten Bauteile bzw. Vorrichtungen bekannt.

Weiterhin beinhaltet die Erfindung ein Verfahren zur Herstellung von Verbindungen umfassend mindestens eine Diazadiborin-Teilstruktur, das dadurch gekennzeichnet ist, dass o-Phenylbisborate der allgemeinen Formel (II), 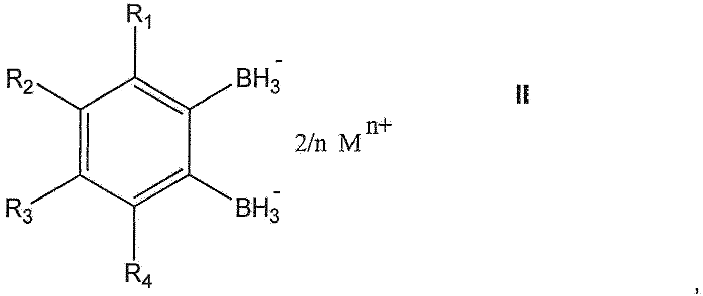 mit Hydrazobenzolen der allgemeinen Formel (III) oder Azobenzolen der allgemeinen Formel (IV), 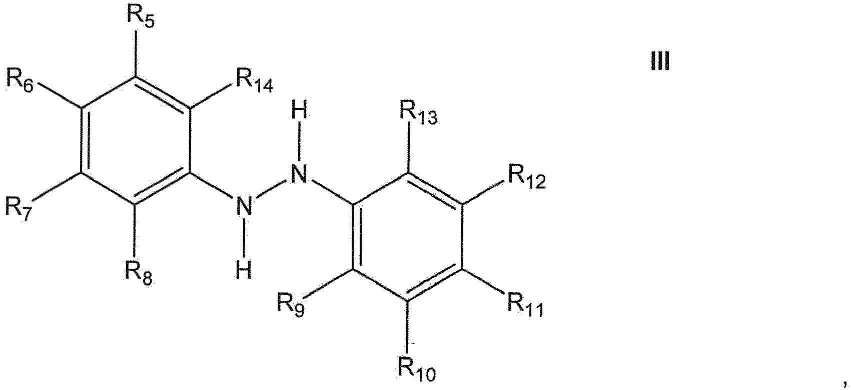 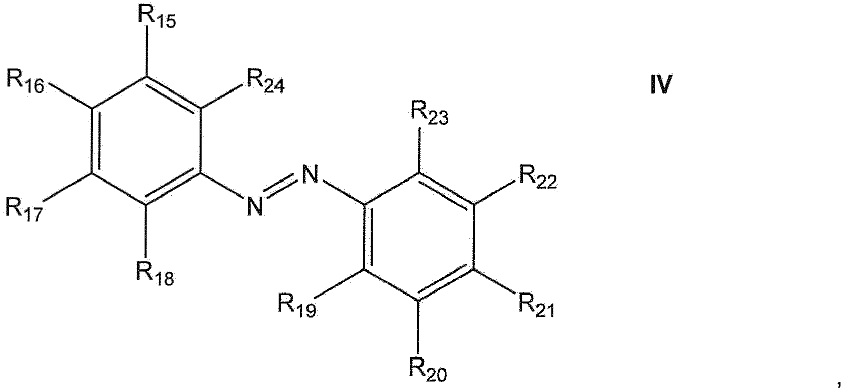 umgesetzt werden. Bei den Resten R₁ bis R₂₄ handelt es sich dabei um Reste, die unabhängig voneinander ausgewählt sind aus der Liste umfassend H, F, Cl, Br, I, CN, OH, O-Alkyl, NH₂, N(Alkyl)₂, C₁-C₂₀-Alkyl, C₁-C₂₀-iso-Alkyl, C₃-C₂₀-Cycloalkyl, Cyclopentadienyl, Aryl, Phenyl, Benzyl, Naphthyl, Heteroaryl, polyzyklische aromatische Reste, polyzyklische heteroaromatische Reste, substituiertes C₁-C₂₀-Alkyl, substituiertes C₁-C₂₀-iso-Alkyl, substituiertes C₃-C₂₀-Cycloalkyl, substituiertes Aryl, substituiertes Phenyl, substituiertes Benzyl, substituiertes Naphthyl, substituiertes Heteroaryl, substituierte polyzyklische aromatische Reste, substituierte polyzyklische heteroaromatische Reste, wobei bei den substituierten Resten dieser Liste mindestens ein Wasserstoffatom im Rest substituiert ist durch einen Rest, ausgewählt aus der Liste umfassend F, Cl, Br, I, CN, OH, O-Alkyl, NH₂, N(Alkyl)₂, C₁-C₂₀-Alkyl, Phenyl, Benzyl, wobei im Falle mehrfacher Substitution die Substituenten unabhängig voneinander ausgewählt sind, und es sich bei den Kationen Mⁿ⁺ um Kationen handelt, ausgewählt aus der Liste umfassend Li⁺, Na⁺, K⁺, Rb⁺, Cs⁺, Mg²⁺, Ca²⁺, Al³⁺.

Weiterhin beinhaltet die Erfindung ein Verfahren wie vorstehend beschrieben, das weiterhin dadurch gekennzeichnet ist, dass der Reaktionsmischung ein Reagenz zur Abspaltung eines Hydrids zugesetzt wird, ausgewählt aus der Liste umfassend Trimethylsilylchlorid (TMSCI), TMSOTf, Ph₃CBF₄, HF, HCl, HBr, HI.

Dem Fachmann ist bekannt, daß die weiter unten offenbarten Ausführungsbeispiele des erfindungsgemäßen Verfahrens nicht einschränkend zu verstehen sind, da es sich um für die jeweilige erfindungsgemäße Verbindung zumindest teilweise optimierte Durchführungsvariante handelt. Insbesondere ist es dem Fachmann naheliegend und fällt in den Umfang der Erfindung, daß
a) das erfindungsgemäße Verfahren in einem weiten Temperaturbereich durchführbar ist werden kann, zum Beispiel bei einer Temperatur von 0 °C bis 200 °C, bevorzugt bei einer Temperatur von 20 °C bis 150 °C, besonders bevorzugt bei einer Temperatur von 50 °C bis 100 °C;
b) das erfindungsgemäße Verfahren wie bisher beschrieben in verschiedensten Lösungsmitteln oder Lösungsmittelgemischen durchführbar ist, wobei mindestens ein Lösungsmittel enthalten ist, das ausgewählt ist aus der Liste umfassend aliphatische Kohlenwasserstoffe, aromatische Kohlenwasserstoffe, heteroaromatische Kohlenwasserstoffe, aliphatische Ether, aromatische Ether, gemischte Ether, Benzol, Toluol;
c) das erfindungsgemäße Verfahren wie bisher beschrieben, derart durchgeführt wird, dass während der Umsetzung das Lösungsmittel gewechselt wird, beispielsweise durch Abdestillieren, ggf. unter Vakuum;
d) das erfindungsgemäße Verfahren wie bisher beschrieben, unterschiedlichste Reaktionszeiten umfasst, beispielsweise in Abhängigkeit von der Reaktivität der Edukte bzw. Reagenzien und/oder der gewählten Lösungsmittel, so dass die Dauer der Umsetzung 0,25 h bis 72 h, besonders bevorzugt 2,0 h bis 36 h und ganz besonders bevorzugt 5 h bis 24 h beträgt;
e) das erfindungsgemäße Verfahren wie bisher beschrieben derart durchgeführt wird, dass die Temperatur der Reaktionsmischung während der Umsetzung variiert wird, und
f) das erfindungsgemäße Verfahren wie bisher beschrieben derart durchgeführt wird, dass die Umsetzung zumindest teilweise unter Druck durchgeführt wird.

Weiterhin beinhaltet die Erfindung die Verwendung mindestens einer der erfindungsgemäßen Verbindungen oder mindestens einer der erfindungsgemäßen Zubereitungen als Wasserstoff-Speichermaterial, ähnlich wie beispielsweise Dekalin als Wasserstoffspeichermaterial verwendet wird.

### Ausführungsbeispiele

Nachfolgend wird zunächst anhand der Synthese von Verbindung 3a beispielhaft das Vorgehen bei der Durchführung des erfindungsgemäßen Verfahrens beschrieben, das ein einfaches und kostengünstiges sowie vielseitig einsetzbares Verfahren für die Herstellung der erfindungsgemäßen Diazadiborine darstellt, zahlreiche unterschiedliche Reste toleriert, und ohne den Einsatz von Übergangsmetall-Katalysatoren oder toxischen metallorganischen Verbindungen auskommt. Mit den nachfolgenden Beschreibungen wird der Umfang der Erfindung nicht eingeschränkt. Dem Fachmann ist bekannt, dass zahlreiche weitere polaraprotische und unpolare Lösungsmittel bzw. Lösungsmittelgemische in variablen Mengen verwendet werden können, ohne den Umfang der Erfindung zu verlassen, um die Reaktionsführung für die jeweilige erfindungsgemäße Verbindung zu optimieren und/oder den gewünschten Rahmenbedingungen wie zum Beispiel ökologischen/toxikologischen Aspekten, Nebenproduktspektrum usw. anzupassen. Je nach Wahl von Lösungsmittel bzw. Lösungsmittelkombination und Reaktivität der Edukte können die Reaktionszeiten und Temperaturen sowie Drucke ebenfalls in weiten Grenzen variiert werden, ohne den Umfang der Erfindung zu verlassen.

Die verwendeten Geräte und Chemikalien (Edukte, Lösungsmittel, Trocknungsmittel, NMR-Reagenzien u. dgl.) wurden gemäß allgemein üblicher fachmännischer Praxis gehandhabt; luftempfindliche Verbindungen werden gemäß allgemein bekannter Praxis unter Schutzgas, beispielsweise Stickstoff (N₂) gehandhabt. Die Werte der chemischen Verschiebung (NMR-Spektroskopie) werden in ppm mit Bezug auf das jeweils bekannte Lösungsmittelsignal, bzw. im Falle der "B-NMR-Spektrsokopie gegenüber BF₃*OEt₂ angegeben.

Das verwendete Bisborat **1** sowie die Azoverbindungen **4a** bis **4f** und **5a** bis **5d** wurden gemäß bekannter Literaturvorschriften hergestellt.

In der gesamten vorliegenden Offenbarung wird mehrheitlich bei der Angabe von Dezimalzahlen als Dezimaltrennzeichen der Dezimalpunkt verwendet; vereinzelt kann jedoch synonym auch ein Dezimalkomma verwendet werden.

Allgemeine Arbeitsvorschriften für die Synthese von Diazadiborinen, am Beispiel von Verbindung **3a:**

### a) Unter Verwendung von Azoverbindungen 4:

Jeweils ein Äquivalent Bisborat **1** (55 mg, 0.29 mmol) und Azobenzol **4a** (50 mg, 0.27 mmol) werden bei Raumtemperatur, d.h. bei einer Temperatur im Bereich von 15 °C bis 25 °C, in THF (5 mL) gelöst und mehrere (ca. 6 bis 18) Stunden, z. B. über Nacht, gerührt. Sodann werden das Lösungsmittel vollständig unter Anlegen von Vakuum entfernt und anschließend 2.6 Äquivalente Trimethylsilylchlorid (TMSCI), gelöst in Toluol (4 mL) zugegeben. Nun wird auf 60 °C aufgeheizt und erneut mehrere Stunden gerührt, um die Reaktion zu vervollständigen. Zur Aufbereitung werden zunächst alle leichtflüchtigen Bestandteile der Reaktionsmischung unter Vakuum abgezogen und anschließend das Produkt im Hochvakuum (p < 1 mbar, bevorzugt: p < 0.1 mbar) bei 160 °C sublimiert. Die Sublimation ergab direkt das gewünschte Produkt **3a** in der gewünschten Reinheit und in 34% Ausbeute (weißer Feststoff, 26 mg).

### b) Unter Verwendung von Hydrazoverbindungen 2:

Jeweils ein Äquivalent Bisborat **1** (150 mg, 0.29 mmol) und Hydrazobenzol **2** (143 mg, 0.776 mmol) werden bei Raumtemperatur, d.h. bei einer Temperatur im Bereich von 15 °C bis 25 °C, in THF (6 mL) gelöst und mehrere (ca. 6 bis 18) Stunden, z. B. über Nacht, gerührt. Sodann werden das Lösungsmittel vollständig unter Anlegen von Vakuum entfernt und anschließend 2.6 Äquivalente Trimethylsilylchlorid (TMSCI), gelöst in Toluol (5 mL) zugegeben. Nun wird auf 60 °C aufgeheizt und erneut mehrere Stunden, im vorliegenden Falle für ca. 6 Stunden, gerührt, um die Reaktion zu vervollständigen. Zur Aufbereitung werden zunächst alle leichtflüchtigen Bestandteile der Reaktionsmischung unter Vakuum abgezogen und anschließend das Produkt im Hochvakuum (p < 1 mbar, bevorzugt: p < 0.1 mbar) bei 160 °C sublimiert. Die Sublimation ergab direkt das gewünschte Produkt **3a** in der gewünschten Reinheit und in 32% Ausbeute (weißer Feststoff, 70 mg).

### Spektroskopische Stoffdaten von 3a:

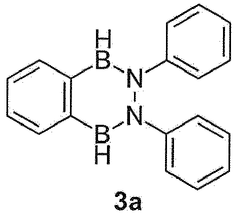

¹H NMR (600 MHz, CDCl₃, 296.8 K): δ = 8.10 (dd, *J_{HH}* = 5.5, 3.2 Hz, 2H), 7.70 (dd, *J_{HH} =* 5.5, 3.2 Hz, 2H), 7.18 (m, 8H), 7.01 (m, 2H), 5.42 (br s, 2H, B*H*) ppm. ¹³C NMR (100.65 MHz, CDCl₃, 296.8 K): δ = 145.6, 136.8, 130.7, 128.3, 126.1, 125.3 ppm. Die den Bor-Atomen benachbarten Kohlenstoff-Atome sind im Spektrum nicht erkennbar. ¹¹B NMR (128.42 MHz, CDCl₃, 296.8 K): δ = 36.05 (br s) ppm. IR (neat) *v* = 3049, 2531, 1597, 1490, 1426, 1320, 749, 690, 658, 507 cm-¹. HRMS (EI) berechnet für C₁₈H₁₆B₂N₂ (M⁺): 282.14995, gefunden: 282.15044.

### Syntheseparameter von 3b:

Bisborat **1** (94 mg, 0.49 mmol, 1.0 Äq.), Azobenzol **4b** (100 mg, 0.476 mmol, 0.971 Äq.) und TMSCI (160 µL, 1.26 mmol, 2.57 Äq.) ergeben 92.5 mg **3b** (63 %) in Form eines weißen Feststoffs. Einkristalle von **3b** werden erhalten durch Umkristallisation aus Toluol bei -20 °C.

### Spektroskopische Stoffdaten von 3b:

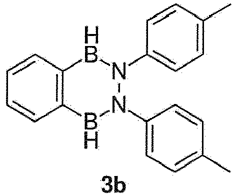

¹H NMR (600 MHz, CDCl₃, 296.8 K): ö = 8.07 (dd, *J =* 5.5, 3.3 Hz, 2H), 7.68 (dd, *J* = 5.5, 3.2 Hz, 2H), 7.05 (m, 4H), 6.96 (m, 4H), 5.35 (br s, 2H, B*H*), 2.23 (s, 6H) ppm. ¹³C NMR (100.65 MHz, CDCl₃, 296.8 K): δ = 143.3, 136.7, 135.0, 130.5, 129.0, 126.1, 21.0 ppm. Die den Bor-Atomen benachbarten Kohlenstoff-Atome sind im Spektrum nicht erkennbar. ¹¹B NMR (128.42 MHz, CDCl₃, 296.8 K): δ = 35.9 (br s) ppm. IR (neat) *v* = 2921, 2543, 1609, 1591, 1508, 1354, 812, 742, 715, 580, 550, 500 cm⁻1. HRMS (EI) berechnet für C₂₀H₂₀B₂N₂ (M⁺): 310.18127, gefunden: 310.18056.

### Kristallographische Daten von 3b sowie Meßparameter:

C₂₀H₂₂B₂N₂, M = 310.00 g/mol, Kristallsystem monoklin, P2₁/n, a = 635.88(6) pm, b = 2129.7(2) pm, c = 1274.38(12) pm, β = 94.477(4)°, V = 1720.2(3) x 10⁶ pm³, Z = 4, p = 1.197 g/cm³, µ = 0.069 cm⁻¹, Mo-Kα Strahlung, λ = 71.073 pm, T = 100 K, θₘᵢₙ₋ₘₐₓ = 2.496 - 24.995°, 37456 Reflexionen aufgenommen, 3038 unabhängige Reflexionen (Rᵢₙₜ = 0.1046) und 2293 beobachtete Reflexionen [I > 2σ(I)], 298 Parameter ohne Einschränkungen verfeinert, R₁/wR₂ [I > 2σ(I)]: 0.0555/0.1051. R₁/wR₂ [sämtliche Daten]: 0.0825/ 0.1134, verbliebene Elektronendichte zwischen 0.279 und -0.182 e⁻/Å³. CCDC 1476496.

### Syntheseparameter von 3c:

Bisborat **1** (88 mg, 0.46 mmol, 1.0 Äq.), Azobenzol **4c** (100 mg, 0.458 mmol, 0.996 Äq.) und TMSCl (150 µL, 1.19 mmol, 2.59 Äq.) ergeben 82.0 mg **3c** (56 %) in Form eines weißen Feststoffes.

### Spektroskopische Stoffdaten von 3c:

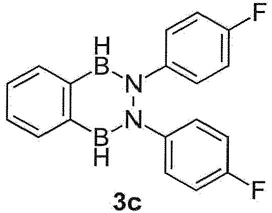

¹H NMR (600 MHz, CDCl₃, 296.8 K): δ = 8.09 (dd, J = 5.5, 3.2 Hz, 2H), 7.71 (dd, *J* = 5.5, 3.2 Hz, 2H), 7.11 (m, 4H), 6.88 (m, 4H), 5.38 (br s, 2H, B*H*) ppm. ¹³C NMR (100.65 MHz, CDCl₃, 296.8 K): δ = 161.1 (d, *J* = 164.0 Hz), 141.5 (d, *J* = 2.1 Hz), 136.8, 130.9, 128.0 (d, *J* = 5.7 Hz), 115.4 (d, *J* = 15.1 Hz) ppm. Die den Bor-Atomen benachbarten Kohlenstoff-Atome sind im Spektrum nicht erkennbar. ¹¹B NMR (128.42 MHz, CDCl₃, 296.8 K): 36.2 (br s) ppm. ¹⁹F NMR (377 MHz, CDCl₃, 296.8 K): δ = -116.5 ppm. IR (neat) *v* = 3051, 2531, 1503, 1357, 1211, 1153, 829, 749, 558, 505, 436 cm⁻¹. HRMS (EI) berechnet für C₁₈H₁₄B₂F₂N₂ (M⁺): 318.13111, gefunden: 318.13157.

### Syntheseparameter von 3d:

Bisborat **1** (91 mg, 0.47 mmol, 1.0 Äq.), Azobenzol **4d** (120 mg, 0.478 mmol, 1.02 Äq.) und TMSCl (158 µL, 1.25 mmol, 2.66 Äq.) ergeben 77 mg **3d** (46 %) in Form eines weißen Feststoffes.

### Spektroskopische Stoffdaten von 3d:

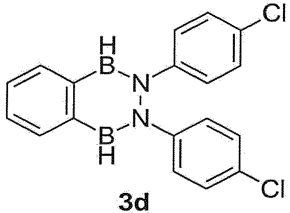

¹H NMR (600 MHz, CDCl₃, 296.8 K): δ = 8.08 (dd, *J* = 5.5, 3.2 Hz, 2H), 7.71 (dd, *J* = 5.5, 3.2 Hz, 2H), 7.16 (m, 4H), 7.10 (m, 4H), 5.43 (br s, 2H, B*H*) ppm. ¹³C NMR (100.65 MHz, CDCl₃, 296.8 K): δ = 144.09, 137.0, 131.1, 131.0, 128.8, 126.9 ppm. Die den Bor-Atomen benachbarten Kohlenstoff-Atome sind im Spektrum nicht erkennbar. ¹¹B NMR (128.42 MHz, CDCl₃, 296.8 K): δ = 36.8 (br s) ppm. IR (neat) *v* = 3051, 2533, 1597, 1481, 1239, 1089, 1005, 817, 749, 711, 643, 579 cm⁻¹. HRMS (EI) berechnet für C₁₈H₁₄B₂Cl₂N₂ (M⁺): 350.07202, gefunden: 350.07316.

### Syntheseparameter von 3e:

Bisborat **1** (85 mg, 0.44 mmol, 1.0 Äq.), Azobenzol **4e** (150 mg, 0.441 mmol, 1.00 Äq.) und TMSCl (144 µL, 1.13 mmol, 2.57 eq.) ergeben 59 mg **3e** (30 %) in Form eines weißen Feststoffes. Einkristalle von **3e** werden erhalten durch Umkristallisation aus Toluol bei -20 °C.

### Spektroskopische Stoffdaten von 3e:

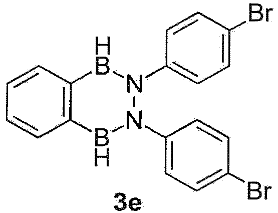

¹H NMR (600 MHz, CDCl₃, 296.8 K): δ = 8.08 (dd, *J* = 5.5, 3.2 Hz, 2H), 7.71 (dd, *J* = 5.5, 3.2 Hz, 2H), 7.32 (m, 4H), 7.05 (m, 4H), 5.42 (br s, 2H, B*H*) ppm. ¹³C NMR (100.65 MHz, CDCl₃, 296.8 K): δ = 144.6, 137.0, 131.8, 131.2, 127.1, 118.8 ppm. Die den Bor-Atomen benachbarten Kohlenstoff-Atome sind im Spektrum nicht erkennbar. ¹¹B NMR (128.42 MHz, CDCl₃, 296.8 K): δ = 36.9 (br s) ppm. IR (neat) *v* = 2959, 2531, 1594, 1486, 1238, 1069, 1000, 814, 748, 699, 579, 498 cm⁻¹. HRMS (EI) berechnet für C₁₈H₁₄B₂Br₂N₂ (M⁺): 437.97097, gefunden: 437.97142.

### Kristallographische Daten von 3e sowie Meßparameter:

C₁₈H₁₆B₂Br₂N₂, M = 439.75 g/mol, Kristallsystem monoklin, *P*2₁/*n,* a = 636.11(3) pm, b = 2140.02(10) pm, *c* = 1275.56(5) pm, β = 92.7906(15)°, *V*= 1734.35(13) x 10⁶ pm³, *Z* = 4, ρ = 1.684 g/cm³, µ = 4.675 cm⁻¹, Mo-Kα Strahlung, λ = 71.073 pm, T = 100 K, θₘᵢₙ₋ₘₐₓ = 2.49 - 25.06°, 40792 Reflexionen aufgenommen, 3079 unabhängige Reflexionen (*R*ᵢₙₜ = 0.0850) und 2595 beobachtete Reflexionen [I > 2σ(*l*)], 270 Parameter ohne Einschränkungen verfeinert, *R*₁/*wR₂* [l > 2σ*(i)*]: 0.0366/0.0619. *R*₁/*wR*₂ [sämtliche Daten]: 0.0508/ 0.0652. verbliebene Elektronendichte zwischen 0.403 und -0.708 e⁻/Å³. CCDC 1476495.

### Syntheseparameter von 6a:

Bisborat **1** (98 mg, 0.51 mmol, 1.0 Äq.), Azobenzol **5a** (110 mg, 0.514 mmol, 1.01 Äq.) und TMSCI (170 µL, 1.34 mmol, 2.62 Äq.) ergeben 24 mg **6a** (15 %) in Form einer farblosen Flüssigkeit.

### Spektroskopische Stoffdaten von 6a:

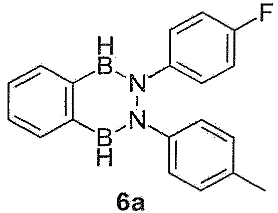

¹H NMR (600 MHz, CDCl₃, 296.8 K): δ = 8.07 (dd, *J* = 5.5, 3.2 Hz, 2H), 7.69 (dd, *J* = 5.5, 3.2 Hz, 2H), 7.11 (m, 2H), 7.02 (d, *J* = 8.3 Hz, 2H), 6.97 (br s, *J* = 8.3 Hz, 2H), 6.85 (t, *J* = 8.6 Hz, 2H), 5.35 (br s, 2H, B*H*), 2.24 (s, 3H) ppm. ¹³C NMR (100.65 MHz, CDCl₃, 296.8 K): δ = 161.0 (d, *J* = 264 Hz), 142.9, 141.8 (d, *J* = 2.1 Hz), 136.8, 135.3, 130.8, 129.1, 127.9 (d, *J* = 5.5 Hz), 126.3, 115.2 (d, *J* = 15.1 Hz), 21.0 ppm. Die den Bor-Atomen benachbarten Kohlenstoff-Atome sind im Spektrum nicht erkennbar. ¹¹B NMR (128.42 MHz, CDCl₃, 296.8 K): 35.9 (br s) ppm. ¹⁹F NMR (377 MHz, CDCl₃, 296.8 K): δ = -117.1 ppm. HRMS (EI) berechnet für C₁₉H₁₇B₂FN₂ (M⁺): 314.15622, gefunden: 314.15762.

### Syntheseparameter von 6b:

Bisborat 1 (101 mg, 0.526 mmol, 1.0 Äq.), Azobenzol **5b** (120 mg, 0.521 mmol, 0.990 Äq.) und TMSCI (172 µL, 1.37 mmol, 2.60 Äq.) ergeben 29 mg **6b** (17 %) in Form einer farblosen Flüssigkeit.

### Spektroskopische Stoffdaten von 6b:

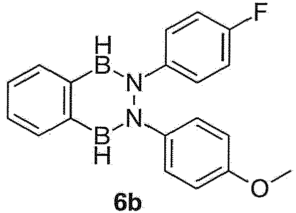

¹H NMR (600 MHz, CDCl₃, 296.8 K): δ = 8.15 (d, *J* = 8.7 Hz, 2H), 7.90 - 7.57 (m, 2H), 7.18 (dd, *J* = 8.9, 4.8 Hz, 2H), 7.14 - 7.08 (m, 2H), 6.93 (dd, *J* = 8.9, 8.3 Hz, 2H), 6.80 - 6.68 (m, 2H), 5.41 (br s, 2H, BH), 3.81 (s, 3H) ppm. ¹³C NMR (100.65 MHz, CDCl₃, 296.8 K): δ = 161.5 (d, *J =* 7.4 Hz), 157.4, 141.7 (d, *J =* 3.2 Hz), 138.6, 136.7, 130.7, 128.3 (d, *J* = 8.3 Hz)" 127.9, 115.2 (d, *J* = 22.7 Hz)" 113.6, 55.5 ppm. Die den Bor-Atomen benachbarten Kohlenstoff-Atome sind im Spektrum nicht erkennbar. ¹⁹F NMR (377 MHz, CDCl₃, 296.8 K): δ = -116.8 ppm. ¹¹B NMR (128.42 MHz, CDCl₃, 296.8 K): 35.0 (br s) ppm. HRMS (EI) berechnet für C₁₉H₁₇B₂FN₂O (M⁺): 330.15112, gefunden: 330.15142.

### Syntheseparameter von 6c:

Bisborat **1** (83 mg, 0.43 mmol, 1.0 Äq.), Azobenzol **5c** (120 mg, 0.430 mmol, 1.00 Äq.) und TMSCI (141 µL, 1.12 mmol, 2.60 Äq.) ergeben 50 mg **6c** (31 %) in Form einer farblosen Flüssigkeit.

### Spektroskopische Stoffdaten von 6c:

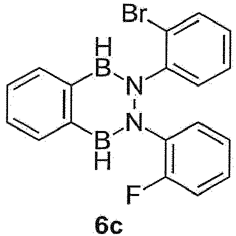

¹H NMR (600 MHz, CDCl₃, 296.8 K): δ = 8.12 (td, *J =* 5.0, 3.2 Hz, 2H), 7.74 (dd, *J* = 5.5, 3.2 Hz, 2H), 7.46 (m, 2H), 7.12 (m, 2H), 6.99 (m, 4H), 5.27 (br s, 2H) ppm. ¹³C NMR (100.65 MHz, CDCl₃, 296.8 K): δ = 159.2, 156.7, 143.5, 136.9, 132.8, 130.7, 130.1, 129.1, 127.6, 124.1, 115.7 (d, *J* = 19.8 Hz) ppm. Die den Bor-Atomen benachbarten Kohlenstoff-Atome sind im Spektrum nicht erkennbar. ¹⁹F NMR (377 MHz, CDCl₃, 296.8 K): δ = - 119.4 ppm. ¹¹B NMR (128.42 MHz, CDCl₃, 296.8 K): 34.9 (br s) ppm. HRMS (EI) berechnet für C₁₈H₁₄B₂BrFN₂ (M⁺): 378.05109, gefunden: 378.05304.

### Abbildungslegenden

- Fig. 1: Kristallstrukturen der Verbindungen **3b** und **3e.**
- Fig. 2: Mesomere Grenzstrukturen von **3b.**
- Fig. 3a: UV-VIS-Spektren ausgewählter 1,2,3,6-Diazadiborine; alle Messungen erfolgten in Cyclohexan bei einer Konzentration von 10⁻⁵ M.
- Fig. 3b: Vergleich der UV-VIS-Spektren von **3a** und 2,3-Diphenylnaphthalin **7,** beide Messungen erfolgten in Cyclohexan bei einer Konzentration von 10⁻⁵ M.
- Fig. 4: Normalisierte Fluoreszenzemissionsspektren ausgewählter 1,2,3,6-Diazadiborine; alle Messungen erfolgten in Cyclohexan bei einer Konzentration von 10⁻⁵ M.
- Fig. 5a: ¹H NMR-Spektrum von Verbindung **3a** in CDCl₃

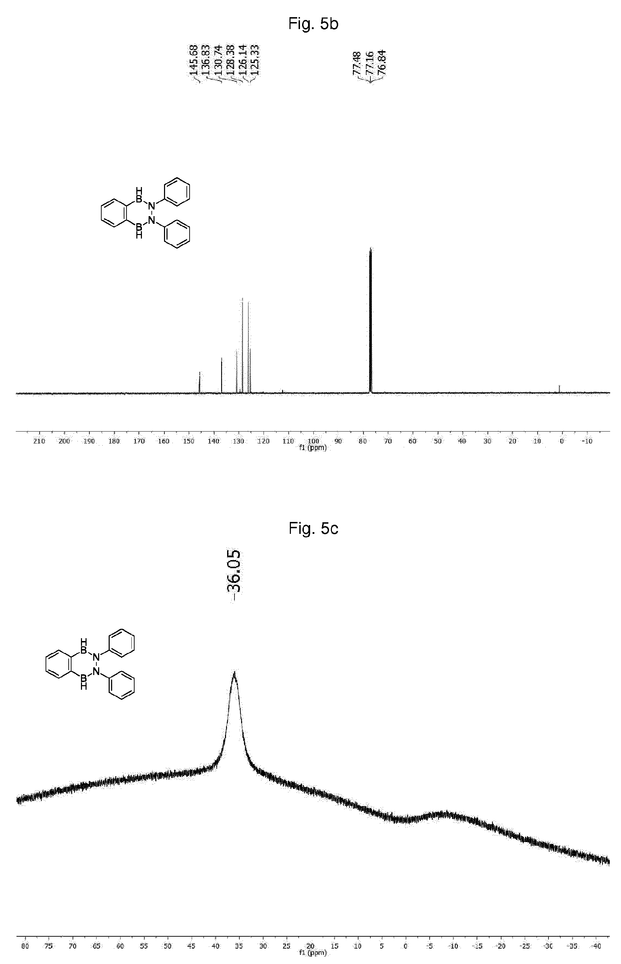

- Fig. 5b: ¹³C NMR-Spektrum von Verbindung **3a** in CDCl₃
- Fig. 5c: ¹¹B NMR-Spektrum von Verbindung **3a** in CDCl₃

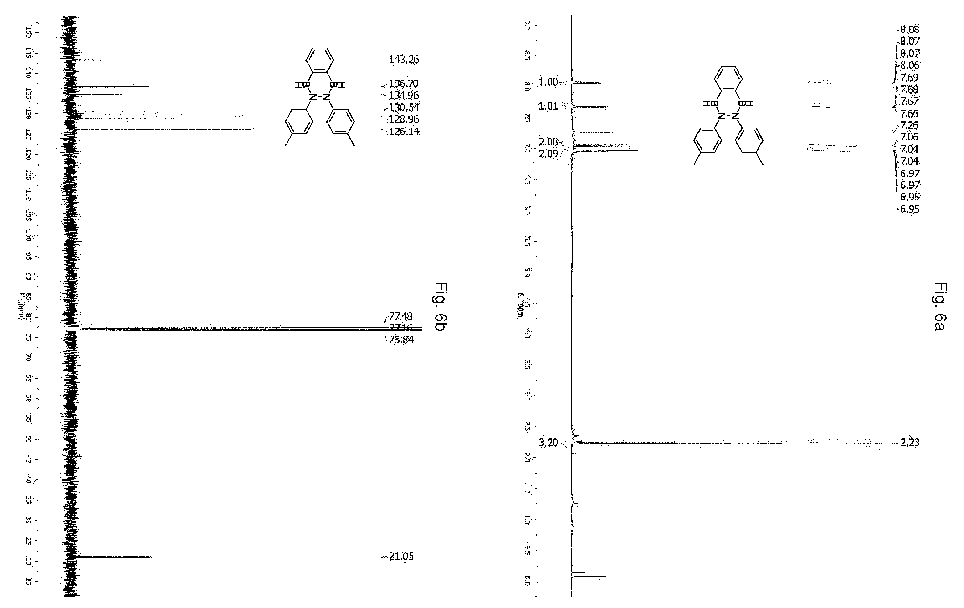

- Fig. 6a: ¹H NMR-Spektrum von Verbindung **3b** in CDCl₃
- Fig. 6b: ¹³C NMR-Spektrum von Verbindung **3b** in CDCl₃
- Fig. 6c: ¹¹B NMR-Spektrum von Verbindung **3b** in CDCl₃
- Fig. 7a: ¹H NMR-Spektrum von Verbindung **3c** in CDCl₃
- Fig. 7b: ¹³C NMR-Spektrum von Verbindung **3c** in CDCl₃
- Fig. 7c: ¹¹B NMR-Spektrum von Verbindung **3c** in CDCl₃
- Fig. 7d: ¹⁹F NMR-Spektrum von Verbindung **3c** in CDCl₃
- Fig. 8a: ¹H NMR-Spektrum von Verbindung **3d** in CDCl₃

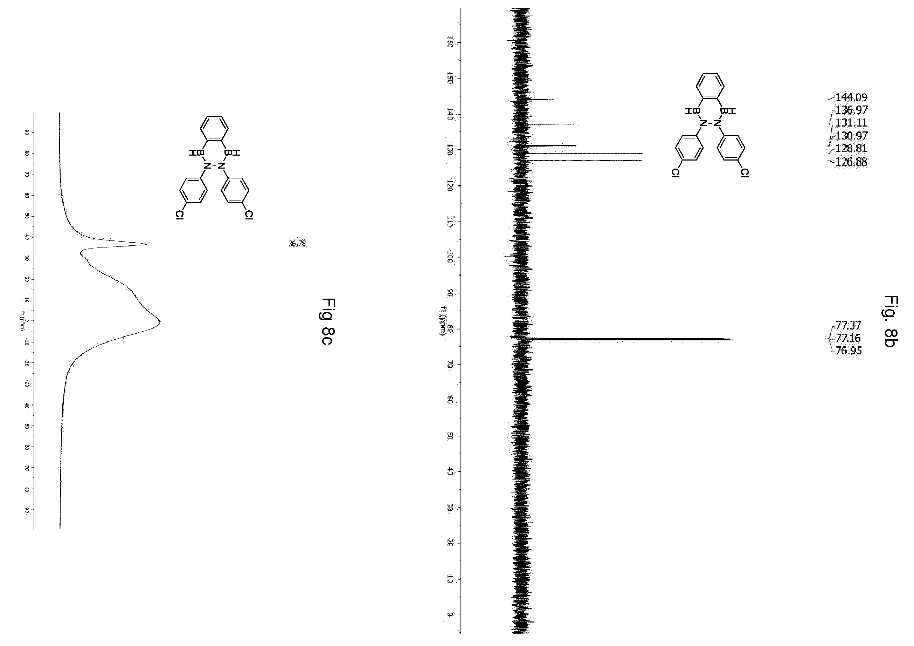

- Fig. 8b: ¹³C NMR-Spektrum von Verbindung **3d** in CDCl₃
- Fig. 8c: ¹¹B NMR-Spektrum von Verbindung **3d** in CDCl₃

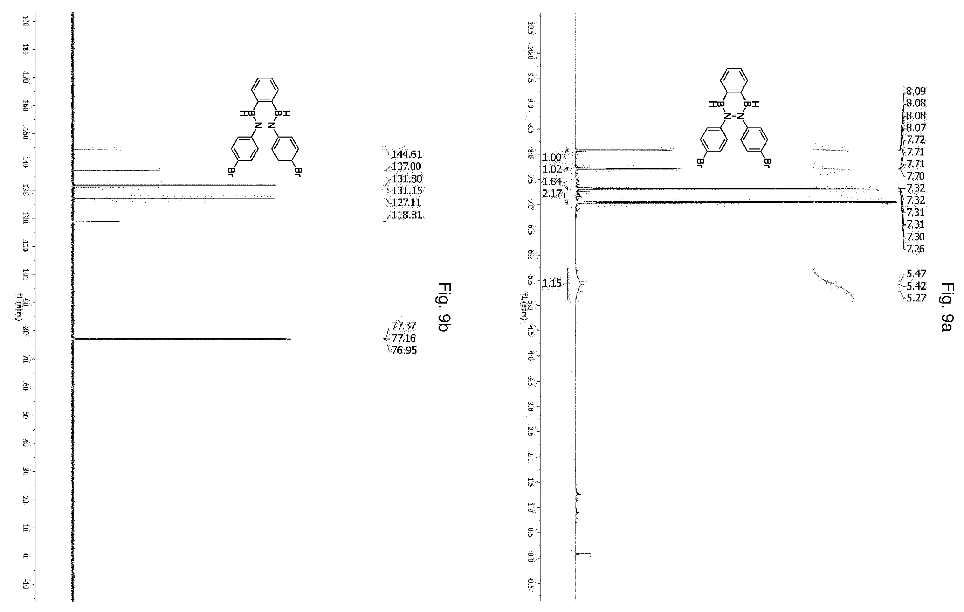

- Fig. 9a: ¹H NMR-Spektrum von Verbindung **3e** in CDCl₃
- Fig. 9b: ¹³C NMR-Spektrum von Verbindung **3e** in CDCl₃

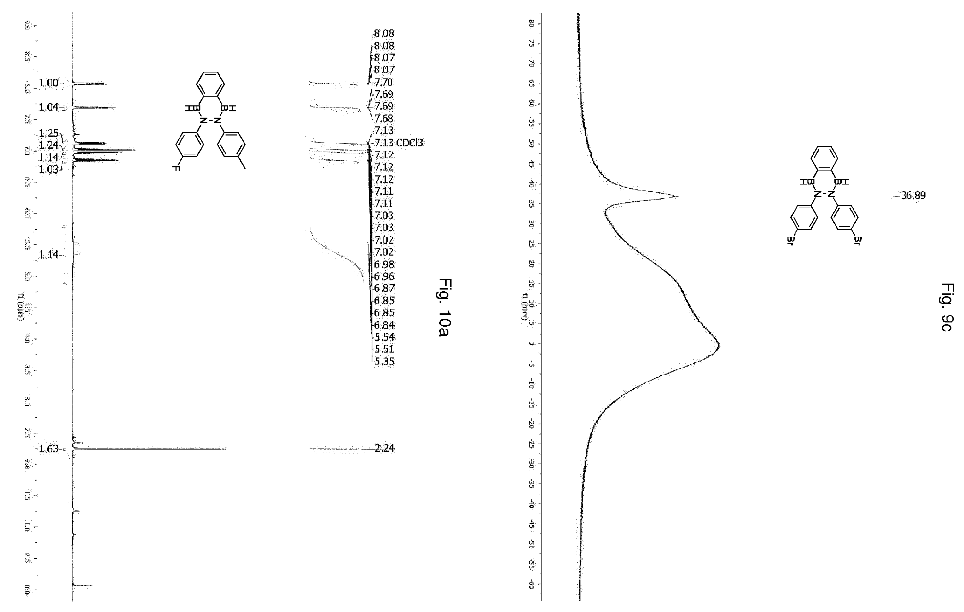

- Fig. 9c: ¹¹B NMR-Spektrum von Verbindung **3e** in CDCl₃
- Fig. 10a: ¹H NMR-Spektrum von Verbindung **6a** in CDCl₃

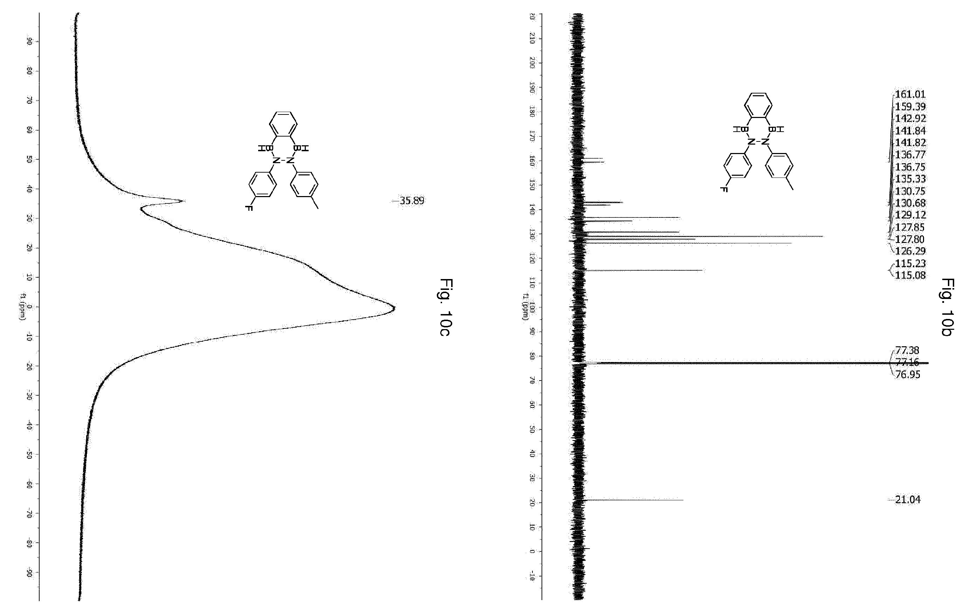

- Fig. 10b: ¹³C NMR-Spektrum von Verbindung **6a** in CDCl₃
- Fig. 10c: ¹¹B NMR-Spektrum von Verbindung **6a** in CDCl₃

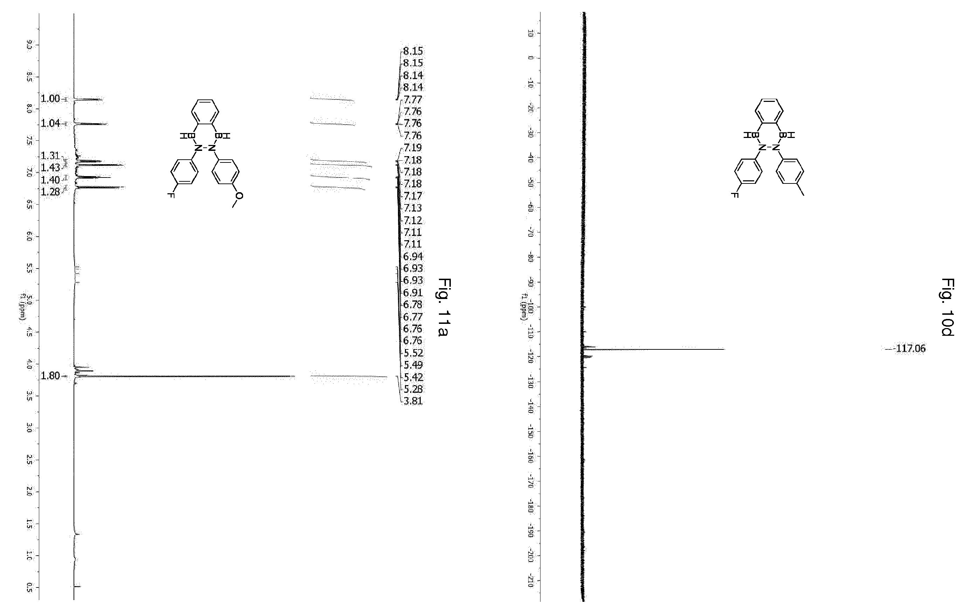

- Fig. 10d: ¹⁹F NMR-Spektrum von Verbindung **6a** in CDCl₃
- Fig. 11a: ¹H NMR-Spektrum von Verbindung **6b** in CDCl₃

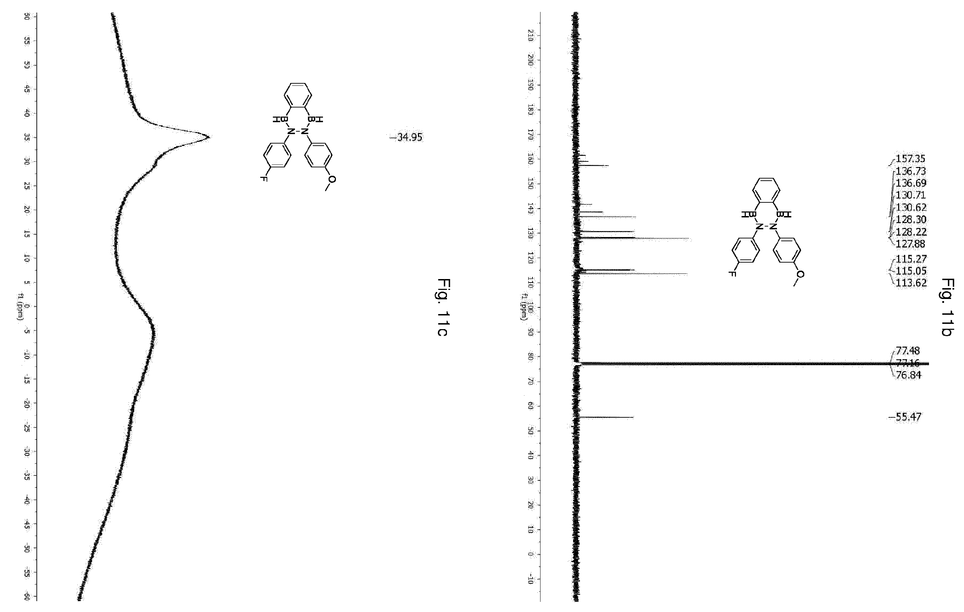

- Fig. 11b: ¹³C NMR-Spektrum von Verbindung **6b** in CDCl₃
- Fig. 11c: ¹¹B NMR-Spektrum von Verbindung **6b** in CDCl₃

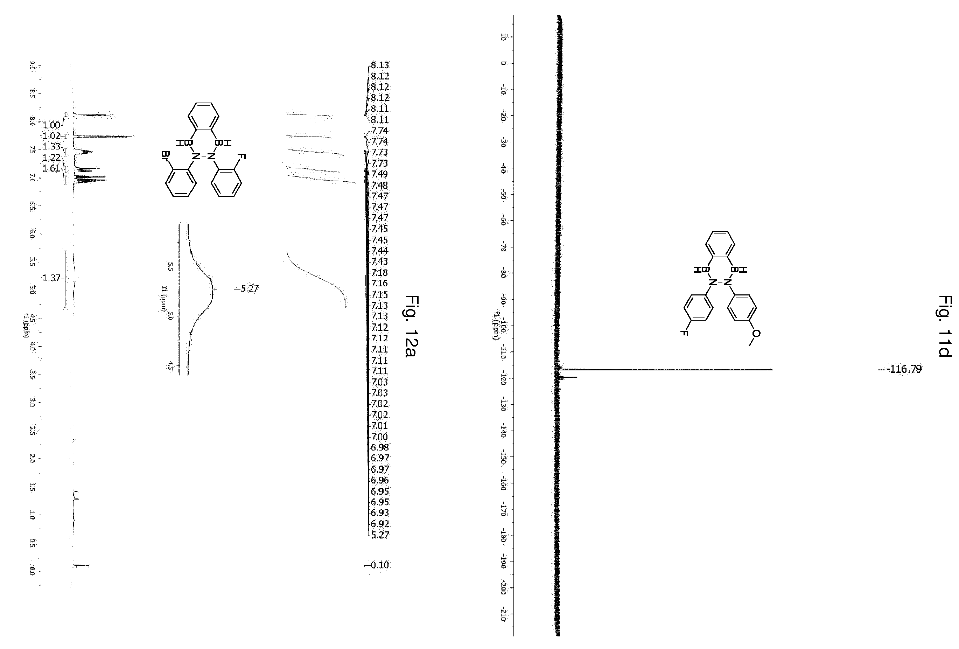

- Fig. 11d: ¹⁹F NMR-Spektrum von Verbindung **6b** in CDCl₃
- Fig. 12a: ¹H NMR-Spektrum von Verbindung **6c** in CDCl₃

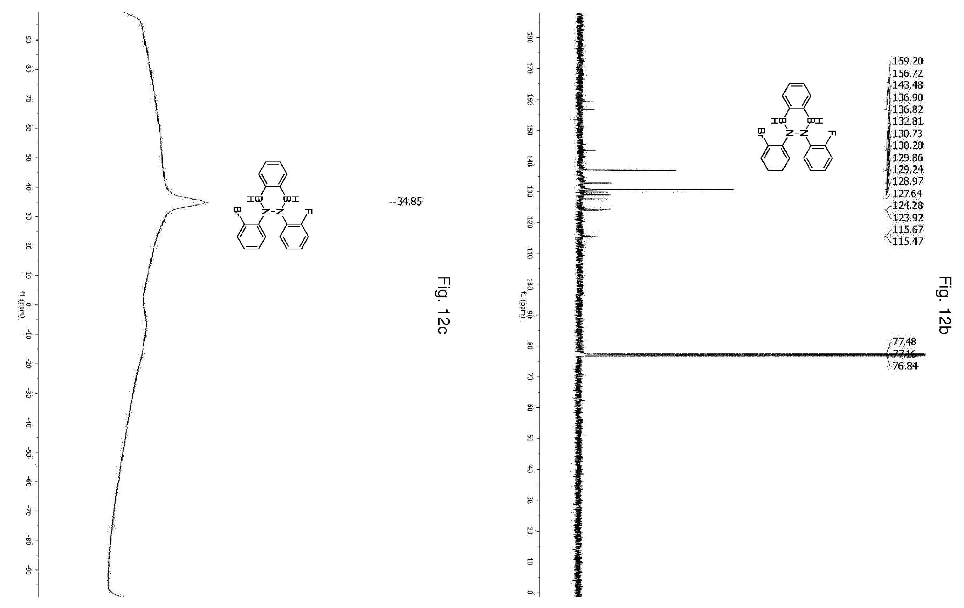

- Fig. 12b: ¹³C NMR-Spektrum von Verbindung **6c** in CDCl₃
- Fig. 12c: ¹¹B NMR-Spektrum von Verbindung **6c** in CDCl₃

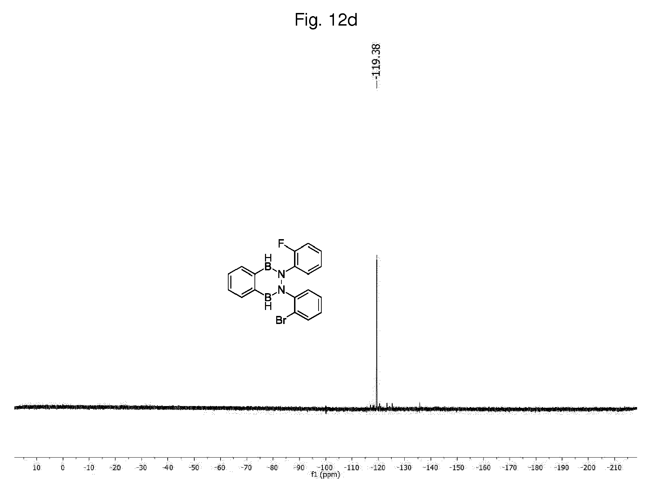

- Fig. 12d: ¹⁹F NMR-Spektrum von Verbindung **6c** in CDCl₃

### Verzeichnis der Abkürzungen

- Tab.: Tabelle
- LM: Lösungsmittel
- Äq.: Äquivalent
- DCM: Dichlormethan
- TMSCI: Trimethylsilylchlorid
- RT: Raumtemperatur

### Anhang: Tabellen zur Beschreibung

**Tab. 1: Versuchsparameter und -ergebnisse der Umsetzunaen gemäß Schema 2**

| Nr.^{[a]} | LM "A" | LM "B" | T/ °C | Ausbeute **3a** [%]^{[b]} |
|---|---|---|---|---|
| 1 | THF | Toluol | 60 | 34 |
| 2 | Toluol | Toluol | 60 | - |
| 3^{[c]} | CH₂Cl₂ | CH₂Cl₂ | RT | 20 |
| 4 | THF | THF | 50 | 17 |
| 5 | THF | Toluol | RT | 29 |
| 6 | THF | CH₂Cl₂ | RT | 23 |

| | | | | |
|---|---|---|---|---|
| ^{[a]} Reaktionsbedingungen: **1** (0.29 mmol), **4a** (0.27 mmol), TMSCl (0.75 mmol), Lösungsmittel (4 mL), Reaktion unter Schutzgas N₂. ^{[b]} isolierte Ausbeute. ^{[c]} TMSCl wurde direkt nach dem Zusammenmischen von **1** und **4a** in DCM zugegeben. | | | | |

**Tab. 2: Versuchsparameter und -ergebnisse der Umsetzungen gemäß Schema 3**

| Nr.^{[a]} | Rest R | Ausbeute **3** [%]^{[b]} |
|---|---|---|
| 1 | H **(4a)** | 34 **(3a)** |
| 2 | Me **(4b)** | 63 **(3b)** |
| 3 | **F (4c)** | 46 **(3c)** |
| 4 | Cl **(4d)** | 56 **(3d)** |
| 5 | Br **(4e)** | 30 **(3e)** |
| 6 | Vinyl (**4f**) | - |

| | | |
|---|---|---|
| ^{[a]} Standard Reaktionsbedingungen: **1** (1.0 Äq.), **4** (1.0 Äq.), TMSCI (2.6 Äq.). ^{[b]} isolierte Ausbeute. | | |

**Tab. 3: Versuchsparameter und -ergebnisse der Umsetzungen gemäß Schema 4**

| Nr.^{[a]} | Rest R¹ | Rest R² | Ausbeute **6** [%]^{[b]} |
|---|---|---|---|
| 1 | 4-Me | 4-F **(5a)** | 15 **(6a)** |
| 2 | 4-OMe | 4-F **(5b)** | 17 **(6b)** |
| 3 | 2-Br | 2-F **(5c)** | 31 **(6c)** |
| 4 | H | 2-NO₂ **(5d)** | - |

| | | | |
|---|---|---|---|
| ^{[a]} Standard Reaktionsbedingungen: 1 (1.0 Äq.), 5 (1.0 Äq.), TMSCl (2.6 Äq.). ^{[b]} isolierte Ausbeute. | | | |

## Patentansprüche

1. Verbindung umfassend mindestens eine Diazadiborin-Teilstruktur der allgemeinen Formel **I**, 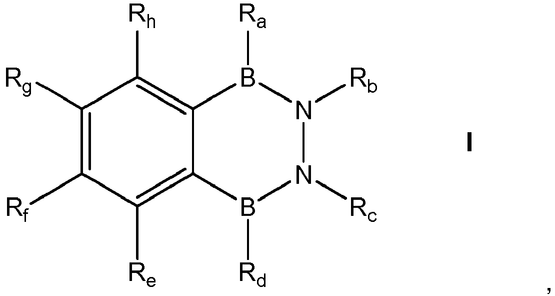 **dadurch gekennzeichnet, dass**
- entweder mindestens zwei der Reste Rₐ bis Rₕ über mindestens eine mindestens einatomige Brücke miteinander verknüpft sind, so dass die bizyklische Diazadiborin-Teilstruktur **I** Bestandteil der polyzyklischen aromatischen oder polyzyklischen heteroaromatischen Struktur der Verbindung ist, und
diejenigen Reste Rₐ bis Rₕ, die nicht Teil der polyzyklischen aromatischen oder polyzyklischen heteroaromatischen Struktur der Verbindung sind, unabhängig voneinander ausgewählt sind aus der Liste umfassend H, F, Cl, Br, I, CN, OH, O-Alkyl, NH₂, N(Alkyl)₂, C₁-C₂₀-Alkyl, C₁-C₂₀-iso-Alkyl, C₃-C₂₀-Cycloalkyl, Cyclopentadienyl, Aryl,
Phenyl, Benzyl, Naphthyl, Heteroaryl, polyzyklische aromatische Reste, polyzyklische heteroaromatische Reste, substituiertes C₁-C₂₀-Alkyl, substituiertes C₁-C₂₀-iso-Alkyl, substituiertes C₃-C₂₀-Cycloalkyl, substituiertes Aryl, substituiertes Phenyl, substituiertes Benzyl, substituiertes Naphthyl, substituiertes Heteroaryl, substituierte polyzyklische aromatische Reste, substituierte polyzyklische heteroaromatische Reste, wobei bei den substituierten Resten dieser Liste mindestens ein Wasserstoffatom im Rest substituiert ist durch einen Rest, ausgewählt aus der Liste umfassend F, Cl, Br, I, CN, OH, O-Alkyl, NH₂, N(Alkyl)₂, C₁-C₂₀-Alkyl, Phenyl, Benzyl, wobei im Falle mehrfacher Substitution die Substituenten unabhängig voneinander ausgewählt sind,
oder
- es sich bei den Resten Rₐ bis Rₕ um Reste handelt, die unabhängig voneinander ausgewählt sind aus der Liste umfassend H, F, Cl, Br, I, CN, OH, O-Alkyl, NH₂, N(Alkyl)₂, C₁-C₂₀-Alkyl, C₁-C₂₀-iso-Alkyl, C₃-C₂₀-Cycloalkyl, Cyclopentadienyl, Aryl,
Phenyl, Benzyl, Naphthyl, Heteroaryl, polyzyklische aromatische Reste, polyzyklische heteroaromatische Reste, substituiertes C₁-C₂₀-Alkyl, substituiertes C₁-C₂₀-iso-Alkyl, substituiertes C₃-C₂₀-Cycloalkyl, substituiertes Aryl, substituiertes Phenyl, substituiertes Benzyl, substituiertes Naphthyl, substituiertes Heteroaryl, substituierte polyzyklische aromatische Reste, substituierte polyzyklische heteroaromatische Reste, wobei bei den substituierten Resten dieser Liste mindestens ein Wasserstoffatom im Rest substituiert ist durch einen Rest, ausgewählt aus der Liste umfassend F, Cl, Br, I, CN, OH, O-Alkyl, NH₂, N(Alkyl)₂, C₁-C₂₀-Alkyl, Phenyl, Benzyl,
wobei im Falle mehrfacher Substitution die Substituenten unabhängig voneinander ausgewählt sind.

2. Verbindung gemäß Anspruch 1, **dadurch gekennzeichnet, dass** es sich bei der polyzyklischen aromatischen oder polyzyklischen heteroaromatischen Struktur dieser Verbindung, die die Teilstruktur gemäß Formel **I** enthält, um eine Struktur handelt, die als mindestens eine weitere Teilstruktur eine oder mehrere Teilstrukturen umfasst, ausgewählt aus der Liste umfassend die Strukturen von Naphthalin, Anthracen, Phenanthren, Phenalen, Tetracen, Pyren, Chrysen, lineares Pentacen, nicht-lineares Pentacen, lineares Hexacen, nichtlineares Hexacen, Inden, Indacen, Fluoren, Acenaphthalen sowie höhermolekulare Homologe dieser Strukturen.

3. Verbindung gemäß Anspruch 1 oder Anspruch 2, **dadurch gekennzeichnet, dass** in der polyzyklischen Struktur randständig und/oder nicht randständig weitere Heteroatome mit oder ohne Substituenten enthalten sind, ausgewählt aus der Liste umfassend B, N, O, S, Se, NR', SiR'₂, wobei es sich bei R' unabhängig voneinander um H, C₁-C₄₀-Alkyl, C₁-C₄₀-Isoalkyl handeln kann.

4. Verbindung gemäß einem der vorangegangenen Ansprüche 1 bis 3, **dadurch gekennzeichnet, dass** es sich um eine niedermolekulare Verbindung, ein Monomer, ein Dimer, ein Oligomer oder ein Polymer handelt.

5. Zubereitung, umfassend mindestens eine Verbindung gemäß einem der Ansprüche 1 bis 4, die mindestens eine der Eigenschaften elektrisch leitend, halbleitend, elektronenleitend, lochleitend, elektrisch isolierend, lichtleitend oder lichtemittierend aufweist, wobei als Zubereitung sowohl einfache physikalische Materialmischungen als auch Polymerkomposite, Copolymere, compoundierte Polymere und dergleichen anzusehen sind.

6. Zubereitung, umfassend mindestens eine Verbindung gemäß einem der Ansprüche 1 bis 4 sowie ein organisches Lösungsmittel oder Lösungsmittelgemisch.

7. Verwendung der Verbindung gemäß einem der Ansprüche 1 bis 4 oder der Zubereitung gemäß einem der Ansprüche 5 bis 6 als Ladungstransport-Material, Halbleiter-Material, elektrisch leitendes Material, lichtleitendes- oder lichtemittierendes Material in optischen, elektrooptischen, elektronischen, elektrolumineszenten oder photolumineszenten Bauteilen oder Vorrichtungen.

8. Bauteil oder Vorrichtung, umfassend mindestens eine Verbindung gemäß einem der Ansprüche 1 bis 4 oder eine Zubereitung gemäß einem der Ansprüche 5 bis 6, wobei dieses Bauteil beziehungsweise diese Vorrichtung ausgewählt ist aus der Liste umfassend Organische Feldeffekt-Transistoren (OFET), Dünnfilmtransistoren (TFT), Integrierte Schaltkreise (IC), Logik-Schaltkreise, Logik-Bausteine, Kondensatoren, Radio-Frequenz-Identifizierungs-Chips (RFID), organische Leuchtdioden (OLED), organische lichtemittierende Transistoren (OLET), Flachbildschirme, Flüssigkristallbildschirme, Hintergrundbeleuchtungen von Flüssigkristallbildschirmen, organische Photovoltaikbauteile (OPV), organische Solarzellen, Photodioden, Laserdioden, Photoleiter, organische Photoleiter, elektrophotographische Bauteile, elektrophotographische Aufzeichnungs-Bauteile, organische Speicherbauteile, Sensorbauteile, Sensoren, Ladungsinjektionsschichten, Ladungstransportschichten oder Zwischenschichten in polymeren Leuchtdioden (PLED), Schottky-Dioden, Ausgleichsschichten, antistatische Beschichtungen und Filme, Polymerelektrolytmembranen (PEM), leitende Substrate, leitfähige Strukturen, Elektrodenmaterialien in Batterien, Sensoren und Elektrolyseuren, Ausgleichsschichten, Biosensoren, Biochips, Sicherheitsmarkierungen, Sicherheits-Vorrichtungen, und Bauteile oder Vorrichtungen für den Nachweis und/oder die Unterscheidung von DNA- oder RNA-Sequenzen.

9. Verfahren zur Herstellung von Verbindungen umfassend mindestens eine Diazadiborin-Teilstruktur, **dadurch gekennzeichnet, dass** *o*-Phenylbisborate der allgemeinen Formel (**II**), 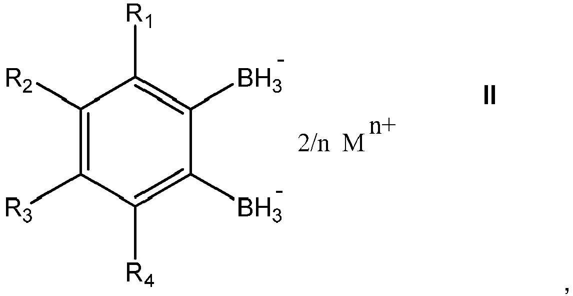 mit Hydrazobenzolen der allgemeinen Formel (**III**) oder Azobenzolen der allgemeinen Formel (**IV**), 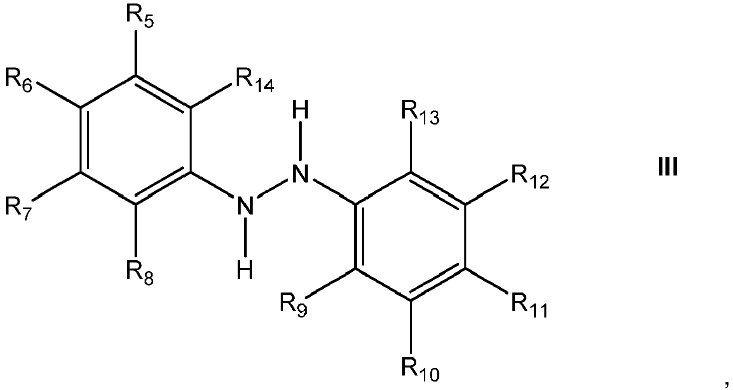 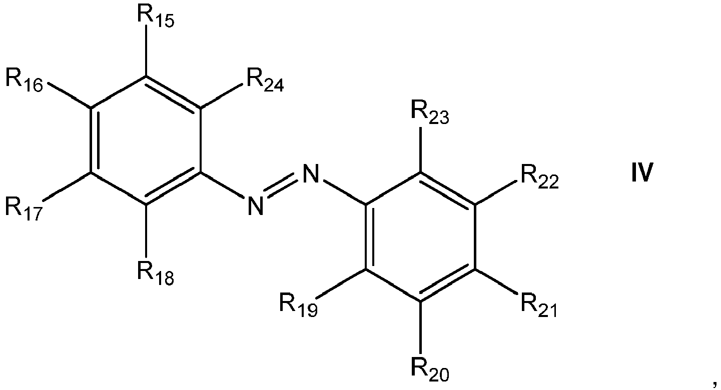 umgesetzt werden, wobei es sich bei den Resten R₁ bis R₂₄ um Reste handelt, die unabhängig voneinander ausgewählt sind aus der Liste umfassend H, F, Cl, Br, I, CN, OH, O-Alkyl, NH₂, N(Alkyl)₂, C₁-C₂₀-Alkyl, C₁-C₂₀-iso-Alkyl, C₃-C₂₀-Cycloalkyl,
Cyclopentadienyl, Aryl, Phenyl, Benzyl, Naphthyl, Heteroaryl, polyzyklische aromatische Reste, polyzyklische heteroaromatische Reste, substituiertes C₁-C₂₀-Alkyl, substituiertes C₁-C₂₀-iso-Alkyl, substituiertes C₃-C₂₀-Cycloalkyl, substituiertes Aryl, substituiertes Phenyl, substituiertes Benzyl, substituiertes Naphthyl, substituiertes Heteroaryl, substituierte polyzyklische aromatische Reste, substituierte polyzyklische heteroaromatische Reste, wobei bei den substituierten Resten dieser Liste mindestens ein Wasserstoffatom im Rest substituiert ist durch einen Rest, ausgewählt aus der Liste umfassend F, Cl, Br, I, CN, OH, O-Alkyl, NH₂, N(Alkyl)₂, C₁-C₂₀-Alkyl, Phenyl, Benzyl, wobei im Falle mehrfacher Substitution die Substituenten unabhängig voneinander ausgewählt sind, und es sich bei den Kationen Mⁿ⁺ um Kationen handelt, ausgewählt aus der Liste umfassend Li⁺, Na⁺, K+, Rb⁺, Cs⁺, Mg²⁺, Ca²⁺, Al³⁺.

10. Verfahren gemäß Anspruch 9, **dadurch gekennzeichnet, dass** der Reaktionsmischung ein Reagenz zur Abspaltung eines Hydrids zugesetzt wird, ausgewählt aus der Liste umfassend Trimethylsilylchlorid (TMSCI), TMSOTf, Ph₃CBF₄, HF, HCl, HBr, Hl.

11. Verfahren gemäß Anspruch 9 oder Anspruch 10, **dadurch gekennzeichnet, dass** die Umsetzung bei einer Temperatur von 0 °C bis 200 °C, bevorzugt bei einer Temperatur von 20 °C bis 150 °C, besonders bevorzugt bei einer Temperatur von 50 °C bis 100 °C durchgeführt wird.

12. Verfahren gemäß einem der vorangegangenen Ansprüche 9 bis 11, **dadurch gekennzeichnet, dass** die Umsetzung in einem Lösungsmittel oder Lösungsmittelgemisch durchgeführt wird, enthaltend mindestens ein Lösungsmittel, ausgewählt aus der Liste umfassend aliphatische Kohlenwasserstoffe, aromatische Kohlenwasserstoffe, heteroaromatische Kohlenwasserstoffe, aliphatische Ether, aromatische Ether, gemischte Ether, Benzol, Toluol.

13. Verfahren gemäß einem der vorangegangenen Ansprüche 9 bis 12, **dadurch gekennzeichnet, dass** während der Umsetzung das Lösungsmittel gewechselt wird.

14. Verfahren gemäß einem der vorangegangenen Ansprüche 9 bis 13, **dadurch gekennzeichnet, dass** die Dauer der Umsetzung 0,25 h bis 72 h, besonders bevorzugt 2,0 h bis 36 h und ganz besonders bevorzugt 5 h bis 24 h beträgt.

15. Verfahren gemäß einem der vorangegangenen Ansprüche 9 bis 14, **dadurch gekennzeichnet, dass** die Temperatur der Reaktionsmischung während der Umsetzung variiert wird.

16. Verfahren gemäß einem der vorangegangenen Ansprüche 9 bis 15, **dadurch gekennzeichnet, dass** die Umsetzung zumindest teilweise unter Druck durchgeführt wird.

17. Verwendung der Verbindung gemäß einem der Ansprüche 1 bis 4 oder der Zubereitung gemäß einem der Ansprüche 5 bis 6 als WasserstoffSpeichermaterial.
